# EUROPEAN PATENT APPLICATION

(11) **EP 4 492 284 A1**
(43) Date of publication of application: **15.01.2025**
(21) Application number: 22930780.6
(22) Date of filing: 08.03.2022
(51) Int. Cl.: G06N 3/04

(54) **INFORMATION PROCESSING DEVICE, INFORMATION PROCESSING METHOD, AND PROGRAM**

(71) Applicant: Softbank Corp., Tokyo 105-7529 (JP)
(72) Inventor: ISHIWAKA, Yuko, Tokyo 105-7529 (JP)
(74) Representative: Betten & Resch
(86) International application number: PCT/JP2022/010059
(87) International publication number: WO 2023/170795

(57) **Abstract**

In order to solve a problem that there has not been any mechanism that can appropriately simulate movements according to cognition of a person, an information processing apparatus 1 includes: a motor neuron firing pattern (MNFP) storage unit 113 in which one or more MNFPs, each of which is information for specifying one or more firing nodes at each of two or more points in time, are stored in association with movement determination information; an MNFP determining unit 131 that applies input information to a neural network (NN), thereby acquiring, in a time series, one or more firing nodes among the two or more nodes included in the NN, and sequentially determines one or more MNFPs corresponding to the one or more time-series firing nodes, from the MNFP storage unit 113; a movement determining unit 132 that sequentially acquires movement determination information respectively corresponding to the one or more MNFPs determined by the MNFP determining unit 131; and a moving unit 133 that moves a movable object 2 sequentially using the one or more pieces of movement determination information. Accordingly, it is possible to appropriately simulate a movement according to cognition of a living organism such as a person.

## Description

### Technical Field

The present invention relates to an information processing apparatus and the like for simulating a movement according to cognition of a living organism such as a person.

### Background Art

Conventionally, there have been techniques for controlling a movement of a movable object such as a robot or an avatar using a neural network (see Patent Document 1, for example).

### Citation List

### Patent Document

Patent Document 1: JP 2022-13786A

### Summary of Invention

### Technical Problem

However, in conventional techniques, there has not been any mechanism that can appropriately simulate movements according to cognition of a living organism such as a person.

### Solution to Problem

A first aspect of the present invention is directed to an information processing apparatus including: a neural network (NN) storage unit in which a neural network having two or more nodes each identified with a node identifier is stored; a motor neuron firing pattern (MNFP) storage unit in which one or two or more MNFPs, each of which is information for specifying one or more firing nodes at each of two or more points in time, are stored in association with movement determination information for determining a movement of a movable object; an input accepting unit that accepts input information; an MNFP determining unit that applies the input information to the neural network, thereby acquiring, in a time series, one or more firing node identifiers of the two or more nodes included in the neural network, and sequentially determines one or more MNFPs corresponding to the one or more time-series firing node identifiers, out of the one or more MNFPs in the MNFP storage unit; a movement determining unit that sequentially acquires movement determination information respectively corresponding to the one or more MNFPs determined by the MNFP determining unit; and a moving unit that moves the movable object sequentially using the one or more pieces of movement determination information acquired by the movement determining unit.

With this configuration, it is possible to simulate a movement according to cognition of a living organism such as a person.

Furthermore, a second aspect of the present invention is directed to the information processing apparatus according to the first aspect, further including: a muscle storage unit in which two or more pieces of muscle information are stored, each of which is information on a muscle that moves in a case in which the one or more nodes fire, is information associated with one or more firing node identifiers, and is information indicating a muscle identifier and a maximum power, wherein the movement determining unit includes: a muscle determining part that sequentially determines one or more pieces of muscle information associated with each of one or more firing node identifiers specified with the one or more MNFPs determined by the MNFP determining unit; and an intensity acquiring part that acquires, for each of the one or more pieces of muscle information determined by the muscle determining part, a firing number, which is the number of firing node identifiers associated with the muscle information, and sequentially acquires intensities of movements of the muscles specified with the muscle information, using the firing number and the maximum power that is indicated by the muscle information, and the moving unit sequentially moves the movable object based on one or more pieces of movement muscle information, each of which is a pair of a muscle identifier contained in each of the one or more pieces of muscle information determined by the muscle determining part and the intensity acquired by the intensity acquiring part.

With this configuration, it is possible to simulate a movement of a muscle according to cognition of a living organism such as a person.

Furthermore, a third aspect of the present invention is directed to the information processing apparatus according to the first aspect, further including: a joint storage unit in which one or more pieces of joint information each having a joint identifier are stored in association with two or more muscle identifiers, wherein the movement determining unit further includes an angle acquiring part that refers to the joint storage unit, and sequentially acquires angles of joints respectively identified with one or more joint identifiers associated with muscle identifiers contained in the one or more pieces of muscle information determined by the muscle determining part, using the one or more pieces of movement muscle information, and the moving unit outputs the angles of the respective one or more joints to the movable object, thereby moving the movable object.

With this configuration, it is possible to simulate a movement of a joint according to cognition of a living organism such as a person.

Furthermore, a fourth aspect of the present invention is directed to the information processing apparatus according to the third aspect, wherein the movable object is an avatar, the joint information is information on a joint of the avatar, and indicates a joint position for specifying a position of a joint included in the avatar, the information processing apparatus further includes an avatar storage unit in which avatar information for outputting the avatar is stored, the moving unit configures an avatar whose joints respectively specified with the joint positions of the one or more joints have been bent according to the angles corresponding to the joints, using the avatar information, and outputs the avatar.

With this configuration, it is possible to simulate a movement of a joint according to cognition of a living organism such as a person, using an avatar.

Furthermore, a fifth aspect of the present invention is directed to the information processing apparatus according to the first aspect, wherein the movable object is a face of an avatar, the information processing apparatus further includes a muscle storage unit in which two or more pieces of muscle information are stored, each of which is information associated with node identifiers of one or more nodes, is information on a mesh that moves in a case in which the one or more nodes fire, and has a muscle identifier for identifying a mesh of the face of the avatar; the movement determining unit includes: a muscle determining part that sequentially determines one or more pieces of muscle information associated with each of one or more firing node identifiers specified with the one or more MNFPs determined by the MNFP determining unit, and the moving unit sequentially stretches or contracts meshes identified with muscle identifiers contained in the muscle information determined by the muscle determining part.

With this configuration, it is possible to simulate a movement of a face according to cognition of a living organism such as a person.

Furthermore, a sixth aspect of the present invention is directed to the information processing apparatus according to the fifth aspect, wherein the movement determining unit includes: a muscle determining part that sequentially determines one or more pieces of muscle information associated with each of one or more firing node identifiers specified with the one or more MNFPs determined by the MNFP determining unit; and an intensity acquiring part that acquires, for each of the one or more pieces of muscle information determined by the muscle determining part, a firing number, which is the number of firing node identifiers associated with the muscle information, and sequentially acquires intensities of movements of the muscles specified with the muscle information, using the firing number, and the moving unit sequentially moves the movable object based on one or more pieces of movement muscle information, each of which is a pair of a muscle identifier contained in each of the one or more pieces of muscle information determined by the muscle determining part and the intensity acquired by the intensity acquiring part.

With this configuration, it is possible to appropriately simulate a movement of a face according to cognition of a living organism such as a person.

Furthermore, a seventh aspect of the present invention is directed to the information processing apparatus according to the first aspect, wherein the movement determination information is a movement identifier for identifying a movement, the information processing apparatus further includes a module storage unit in which a movement module for moving the movable object is stored in association with the movement identifier, the movement determining unit acquires a movement identifier corresponding to the MNFP determined by the MNFP determining unit, and the moving unit executes the movement module associated with the movement identifier acquired by the movement determining unit, thereby moving the movable object.

With this configuration, it is possible to simulate a movement according to cognition of a living organism such as a person.

Furthermore, an eighth aspect of the present invention is directed to the information processing apparatus according to any one of the second to fourth aspects, further including: a muscle changing unit that performs change processing for increasing a maximum power that is paired with a muscle identifier determined by the muscle determining part, in a case in which the muscle identifier satisfies a predetermined increase condition.

With this configuration, it is possible to simulate a movement of a muscle according to cognition of a living organism such as a person, considering the properties of the muscle.

Furthermore, a ninth aspect of the present invention is directed to the information processing apparatus according to any one of the second to fourth aspects, further including: a muscle changing unit that performs change processing for decreasing a maximum power that is paired with a muscle identifier not determined by the muscle determining part, in a case in which the muscle identifier satisfies a predetermined decrease condition.

With this configuration, it is possible to simulate a movement of a muscle according to cognition of a living organism such as a person, considering the properties of the muscle.

Furthermore, a tenth aspect of the present invention is directed to the information processing apparatus according to any one of the first to ninth aspects, further including: a learning unit that performs learning processing for acquiring an MNFP in a case in which the input accepting unit accepts input information, accepts movement determination information, and accumulates the MNFP in the MNFP storage unit in association with the movement determination information.

With this configuration, it is possible to learn an MNFP for controlling a movement according to cognition of a living organism such as a person.

Furthermore, an eleventh aspect of the present invention is directed to the information processing apparatus according to any one of the first to ninth aspects, wherein each of one or more nodes among the two or more nodes included in the neural network is associated with a firing condition, and is associated with one or more connected node identifiers for identifying another node to which firing is to be propagated, and the MNFP determining unit includes: an initial determining part that acquires one or more pieces of feature information from the input information accepted by the input accepting unit, determines a firing condition that matches the one or more pieces of feature information, and acquires one or more firing node identifiers corresponding to the firing condition; a propagating part that acquires one or more connected node identifiers corresponding to each of the one or more firing node identifiers acquired by the initial determining part, and then sequentially acquires one or more connected node identifiers corresponding to each of the one or more connected node identifiers; and an MNFP determining part that acquires, in a time series, firing information having one or more firing node identifiers among the one or more firing node identifiers and the one or more connected node identifiers acquired by the initial determining part and the propagating part, and sequentially determines one or more MNFPs corresponding to the time-series firing information out of the one or more MNFPs in the MNFP storage unit.

With this configuration, it is possible to simulate a movement according to cognition of a living organism such as a person.

Furthermore, a twelfth aspect of the present invention is directed to the information processing apparatus according to any one of the first to eleventh aspects, wherein the number of points in time is different between at least two MNFPs among the two or more MNFPs.

With this configuration, it is possible to appropriately simulate a movement according to cognition of a living organism such as a person.

### Advantageous Effects of Invention

With the information processing apparatus according to the present invention, it is possible to appropriately simulate a movement according to cognition of a living organism such as a person.

### Brief Description of Drawings

FIG. 1 is a block diagram of a movement system A in Embodiment 1.
FIG. 2 is a flowchart illustrating an operation example of an information processing apparatus 1 in the embodiment.
FIG. 3 is a flowchart illustrating an example of initial determining processing in the embodiment.
FIG. 4 is a flowchart illustrating an example of MNFP determining processing in the embodiment.
FIG. 5 is a flowchart illustrating an example of moving processing in the embodiment.
FIG. 6 is a flowchart illustrating an example of angle acquiring processing in the embodiment.
FIG. 7 is a flowchart illustrating an example of fire propagating processing in the embodiment.
FIG. 8 is a flowchart illustrating an example of fire extinguishing processing in the embodiment.
FIG. 9 is a schematic diagram illustrating a specific operation example of the movement system A in the embodiment.
FIG. 10 is a diagram showing an NN management table in the embodiment.
FIG. 11 is a diagram showing an MNFP management table in the embodiment.
FIG. 12 is a diagram showing a muscle management table in the embodiment.
FIG. 13 is a diagram showing a joint management table in the embodiment.
FIG. 14 is a diagram showing an example of firing information in the embodiment.
FIG. 15 is a block diagram of a movement system B in Embodiment 2.
FIG. 16 is a flowchart illustrating an example of moving processing that is performed by an information processing apparatus 3 in the embodiment.
FIG. 17 is a block diagram of a movement system C in Embodiment 3.
FIG. 18 is a flowchart illustrating an example of moving processing that is performed by the information processing apparatus 3 in the embodiment.
FIG. 19 is a flowchart illustrating an example of learning processing in the embodiment.
FIG. 20 is a flowchart illustrating an example of MNFP accumulating processing in the embodiment.
FIG. 21 is a schematic view of a computer system in the embodiments.
FIG. 22 is a block diagram of the computer system in the embodiments.

### Description of Embodiment

Below, embodiments of an information processing apparatus and the like will be described with reference to the drawings. The constituent elements denoted by the same reference numerals in the embodiments perform similar operations, and thus a description thereof may not be repeated.

### Embodiment 1

In this embodiment, an information processing apparatus that can appropriately simulate a movement according to cognition of a living organism such as a person will be described. Specifically, in this embodiment, an information processing apparatus will be described that accepts input information such as an image or a speech, applies the input information to one or two or more stored neural networks, thereby acquiring one or more motor neuron firing patterns (hereinafter referred to as "MNFPs" as appropriate) for specifying time-series firing states of one or more nodes, which are output from the neural networks, acquires movement determination information corresponding to the MNFPs, and move a movable object according to the one or more pieces of movement determination information.

In this specification, the state in which information X is associated with information Y means that the information Y can be acquired from the information X or the information X can be acquired from the information Y, and there is no limitation on the method for associating the information. The information X and the information Y may be linked to each other or in the same buffer. The information X may be contained in the information Y, or the information Y may be contained in the information X, for example.

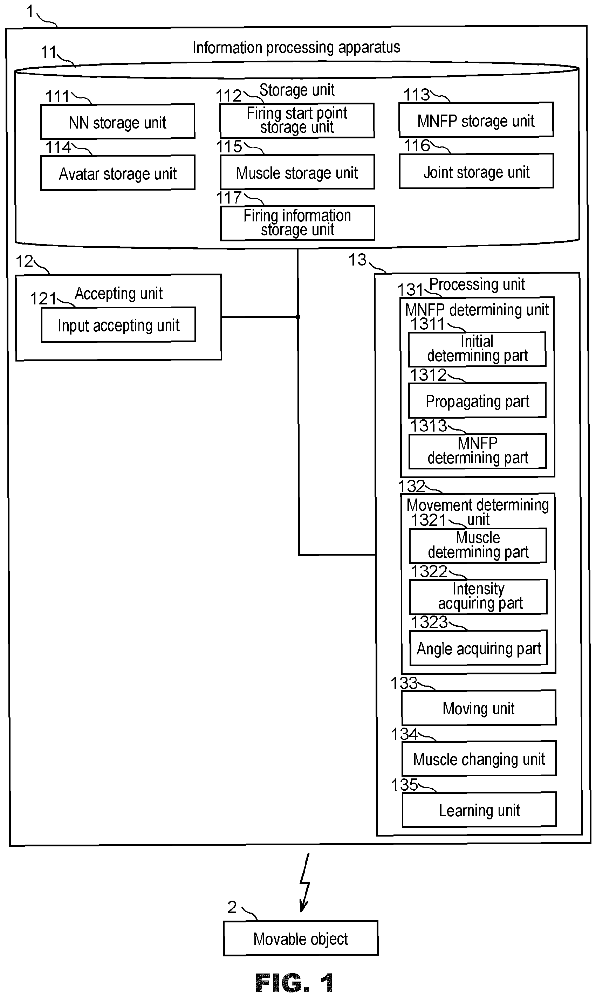

FIG. 1 is a block diagram of a movement system A in this embodiment.

The movement system A includes an information processing apparatus 1 and a movable object 2. The information processing apparatus 1 may be configured to include the movable object 2.

The information processing apparatus 1 is an apparatus that accepts input information and moves the movable object 2 according to the input information.

The movable object 2 is an object that moves. The movable object 2 is, for example, an avatar or a robot, but the type thereof is not limited.

The information processing apparatus 1 includes a storage unit 11, an accepting unit 12, and a processing unit 13. The storage unit 11 includes an NN storage unit 111, a firing start point storage unit 112, an MNFP storage unit 113, an avatar storage unit 114, a muscle storage unit 115, a joint storage unit 116, and a firing information storage unit 117. The accepting unit 12 includes an input accepting unit 121. The processing unit 13 includes an MNFP determining unit 131, a movement determining unit 132, a moving unit 133, a muscle changing unit 134, and a learning unit 135. The MNFP determining unit 131 includes an initial determining part 1311, a propagating part 1312, and an MNFP determining part 1313. The movement determining unit 132 includes a muscle determining part 1321, an intensity acquiring part 1322, and an angle acquiring part 1323.

Various types of information are stored in the storage unit 11 constituting the information processing apparatus 1. The various types of information are, for example, a later-described neural network (hereinafter referred to as an "NN" as appropriate), later-described firing start point information, a later-described MNFP, later-described avatar information, later-described muscle information, later-described joint information, or an extinguishing condition. If the movable object 2 is not an avatar, the avatar information does not have to be stored in the storage unit 11.

The extinguishing condition is a condition for a firing node to become a non-firing node. The extinguishing condition is typically a condition regarding the elapsed time since firing. The extinguishing condition is, for example, that the length of the elapsed time since firing is greater than or equal to a threshold value or is greater than the threshold value. A firing node is a node that is firing. A non-firing node is a node that is not firing.

One or two or more neural networks (hereinafter referred to as "NNs" as appropriate) are stored in the NN storage unit 111. The NN has two or more pieces of node information each identified with a node identifier. The node information is information on a node constituting an NN. The node information has, for example, a node identifier and a firing condition. The node information has, for example, one or more connected node identifiers. The node information may have, for example, a propagation probability associated with each of the one or more connected node identifiers. The node information may have, for example, one or more source identifiers.

The node identifier is information for identifying a node. The node identifier is, for example, an ID of a node or a name of a node.

The firing condition is a condition for the node to fire. The firing condition may also be said to be information on a condition for the node to fire. The firing condition is, for example, a condition regarding one or more pieces of feature information. For example, the feature information may be an information identifier for identifying information, information having an information identifier and an information quantity that indicates the size of the information, or only an information quantity.

The information identifier is, for example, information for specifying the type of feature value of an image, and is, for example, red "R" constituting a color, green "G" constituting a color, or blue "B" constituting a color. The information identifier is, for example, information for specifying the type of speech feature value, and is, for example, "frequency", "amplitude", or the like. The information identifier is, for example, the class of a character string. The class is a result of the classification of the character string. The class is, for example, "positive" or "negative". The class is, for example, "delightful", "angry", "sad", or "happy". The technique of classifying character strings into classes is a known technique, and thus a detailed description thereof has been omitted.

The information quantity is, for example, a numerical value greater than zero.

The firing condition is, for example, "feature information >= 0.5", "feature information > 0.7", "information quantity >= 0.5", "information quantity > 0.7", "(information identifier = A & information quantity >= 0.5) & (information identifier = B & information quantity > 0.8)", or the like. The feature information constituting a firing condition is, for example, a feature value, but may also be input information itself. The feature value is, for example, a feature value of an image resulting from image analysis, and is, for example, "R", "G", or "B". The feature value is, for example, a feature value of speech sounds resulting from speech analysis, and is, for example, frequency or amplitude. The firing condition is preferably associated with a firing probability. The firing probability is information on a probability of firing. The firing probability may be a probability of firing itself, a value converted from the probability of firing by a function, or the like. It is preferable that if the firing condition is satisfied, the firing probability is referenced and the node fires or does not fire according to the probability indicated by the firing probability.

The processing according to a probability such as the firing probability or the propagation probability can be similar to, for example, weighted lottery according to a probability. The probability here can be substituted with likelihood.

The connected node identifier is identification information of a connected node. The connected node is a node connected to a node of interest and is a destination node to which the firing is propagated after the node of interest fires.

The propagation probability is a probability that a firing will propagate.

The source identifier is identification information of a source node. The source node is a node connected to a node of interest and is a node from which the firing is propagated to the node of interest after the source node fires.

One or two or more pieces of firing start point information are stored in the firing start point storage unit 112. The firing start point information is information for specifying a node that fires first when input information is accepted.

The firing start point information has, for example, one or two or more firing node identifiers. The firing start point information has, for example, a firing condition and one or two or more firing node identifiers. The firing node identifier is information for identifying a firing node.

The firing condition in this case is a condition regarding input information. The firing condition is, for example, a condition regarding one or more pieces of feature information. The firing condition has, for example, an information identifier for identifying feature information. The firing condition is, for example, specific feature information or information that indicates the range of specific information. The firing condition is, for example, red "R" constituting a color, green "G" constituting a color, blue "B" constituting a color, sound wavenumber "30", sound frequency "60", sound frequency "between a threshold value A and a threshold value B", the class of the string being a specific class (e.g., "negative"), or the like.

It is also possible that the firing start point storage unit 112 is not provided and a node that fires first when input information is accepted is specified using a firing condition that is paired with a node identifier for identifying node information of an NN in the NN storage unit 111. That is to say, the firing start point storage unit 112 is useful to speed up the processing for specifying a node that fires first when input information is accepted.

One or two or more motor neuron firing patterns (hereinafter referred to as "MNFPs" as appropriate) are stored in the MNFP storage unit 113. Each of the one or more MNFPs in this case is directly or indirectly associated with movement determination information.

The MNFP is information for controlling a movement of the movable object 2. The MNFP is information for specifying one or more firing nodes at each of two or more points in time. The MNFP is information for specifying a set of time-series firing nodes. The set of firing nodes is typically two or more firing nodes, but may also be one firing node.

The MNFP is, for example, information on a matrix of two axes consisting of a time axis and a node identifier. That is to say, the MNFP is, for example, a set of vectors corresponding to two or more points in time. The vectors in this case are information for specifying one or more firing node identifiers. The vectors are, for example, "(n1, n2, ..., nn) = (1, 0, ..., 1)". In the vectors, "n1", "n2", ..., and "nn" are node identifiers. The value "1" indicates that a node identified with its corresponding node identifier is a firing node. The value "0" indicates that a node identified with its corresponding node identifier is a non-firing node.

The MNFP is, for example, a set of two or more vectors having a time identifier for identifying two or more points in time and one or more firing node identifiers. The two or more points in time in this case are typically successive points in time. The MNFP is, for example, ["<time identifier> t1 <vector> (1, 0, ..., 1)", "<time identifier> t2 <vector> (1, 1, ..., 1)", ..., "<time identifier> tn <vector> (0, 1, ..., 0)"].

The data structure of the MNFP is not limited. The number of points in time is preferably different between at least two MNFPs among the two or more MNFPs in the MNFP storage unit 113. Different number of points in time means different length of time series. If MNFPs are matrices, matrices, different number of points in time means different number of rows or columns between at least two MNFPs.

The movement determination information is information for determining a movement of the movable object 2. The movement determination information is, for example, one or more pieces of movement muscle information, angles of one or more joints, or one or more movement identifiers.

The movement muscle information is information for specifying a muscle that is to be moved. The movement muscle information is a pair of a muscle identifier and an intensity. The muscle identifier is information for identifying a muscle. The muscle identifier is, for example, an ID of a muscle or a name of a muscle. The intensity is information indicating an intensity when a muscle is stretched and contracted. The intensity may also be an intensity when a muscle is contracted or an intensity when a muscle is stretched.

The angle of a joint is information for specifying the angle of a joint that is to be moved. The angle of a joint is typically associated with a joint identifier. The joint identifier is information for identifying a joint. The joint identifier is, for example, an ID of a joint or a name of a joint.

The movement identifier is information for identifying a movement. The movement identifier is, for example, a name of a module that moves the movable object 2 or an ID of a module that moves the movable object 2. A module may be considered to include not only an execution module but also a function, a method, and the like.

Avatar information is stored in the avatar storage unit 114. The avatar information is information for outputting an avatar. The data structure of the avatar information is not limited. Note that the avatar information typically has model information. The model information is information for configuring the avatar display. The model information has, for example, mesh information, bone information, and material information. The model information has, for example, the data structure "glTF?(GL Transmission Format)?". Note that the data structure of the model information may also be VRM, OBJ, FBX, STL, GLB, COLLADA, or the like, and the type thereof is not limited.

If the information processing apparatus 1 includes the avatar storage unit 114, the movable object 2 is an avatar. In this case, it may be considered that the movable object 2 is stored in the avatar storage unit 114.

Two or more pieces of muscle information are stored in the muscle storage unit 115. The muscle information is information on a muscle that moves in a case in which the one or more nodes fire. The muscle information is information associated with one or more firing node identifiers, and is information indicating a muscle identifier and a maximum power. The moving a muscle means contracting a muscle or stretching a muscle.

The maximum power is information for specifying a maximum power of a muscle. The maximum power is represented by, for example, a numerical value. The range in which the maximum power can be taken may or may not be fixed.

One or two or more pieces of joint information are stored in the joint storage unit 116. The joint information is information on a joint. The joint information typically has a joint identifier. The joint identifier is information for identifying a joint. The joint identifier is, for example, an ID of a joint or a name of a joint. The joint information is associated with muscle identifiers of two or more muscles connected to the joint. A muscle identified with a muscle identifier corresponding to the joint information is a muscle for moving a joint specified with the joint information. The joint information indicates, for example, a joint position. The joint position is information for specifying a position of the joint. The joint position is typically a relative position of the joint within the avatar. The joint position is, for example, the coordinate values (x, y) of the center of gravity of the joint. Note that the data structure of the joint position is not limited.

If the movable object 2 is an avatar, the joint information may be contained in the avatar information.

Two or more pieces of firing information are stored in the firing information storage unit 117. Time-series firing information is stored in the firing information storage unit 117. The time-series firing information is a set of firing information at two or more points in time.

The firing information in this case is information for specifying a node that is currently firing. The firing information is information on the result of the firing. The firing information is information for specifying a node that fired at each of one or more points in time. Time-series firing information has the same structure as an MNFP, for example. That is to say, the firing information is, for example, information for specifying one or more firing nodes at each of two or more points in time.

The accepting unit 12 accepts various types of information and instructions. The various types of information and instructions are, for example, later-described input information. The various types of information and instructions may be input by any input part such as a touch screen, a keyboard, a mouse, or a menu screen.

The input accepting unit 121 accepts input information. The input information is, for example, an image or a speech. Note that the input information may also be a character string such as a sentence.

The accepting in this case is a concept that encompasses accepting information input from an input device such as a keyboard, a mouse, or a touch screen, receiving information transmitted via a wired or wireless communication line, and accepting information read from a recording medium such as an optical disk, a magnetic disk, or a semiconductor memory.

The processing unit 13 performs various types of processing. The various types of processing are, for example, processing that is performed by the MNFP determining unit 131, the movement determining unit 132, the moving unit 133, the muscle changing unit 134, and the learning unit 135. The processing unit 13 performs, for example, later-described fire extinguishing processing. The fire extinguishing processing may be performed by an unshown fire extinguishing unit.

The MNFP determining unit 131 applies the input information accepted by the input accepting unit 121 to an NN stored in the NN storage unit 111, thereby acquiring, in a time series, one or more firing node identifiers of the two or more nodes included in NN, and sequentially determines one or more MNFPs corresponding to the one or more time-series firing node identifiers, out of the one or more MNFPs in the MNFP storage unit 113.

The application processing for applying input information to an NN is, for example, the following processing. That is to say, the MNFP determining unit 131 acquires one or more pieces of feature information from the input information. Next, the MNFP determining unit 131 refers to the NN, and acquires one or more firing node identifiers corresponding to firing information satisfied by the one or more pieces of feature information. Next, the MNFP determining unit 131 sequentially acquires one or more firing node identifiers through propagating processing that is performed by the propagating part 1312, which will be described later. That is to say, the MNFP determining unit 131 acquires one or more firing node identifiers in a time series. This processing is realized by applying input information to an NN.

The one or more MNFPs corresponding to the one or more time-series firing node identifiers are MNFPs that satisfy a correspondence condition.

The MNFPs that satisfy a correspondence condition are, for example, MNFPs that match one or more time-series firing node identifiers. Note that the MNFPs that satisfy a correspondence condition may include an MNFP whose similarity to one or more time-series firing node identifiers is greater than or equal to a threshold value or is greater than the threshold value. The similarity between a matrix constituted by one or more time-series firing node identifiers and an MNFP constituted by a matrix is acquired, for example, by using the percentage of elements that match each other among the elements of the two matrices. The similarity between a matrix constituted by one or more time-series firing node identifiers and an MNFP constituted by a matrix is acquired, for example, by calculating the similarity of vectors of each row of the matrices, and obtaining a representative value (e.g., mean, median) of the two or more similarities as the similarity of the two matrices. The method for calculating the similarity of the two matrices is not limited.

If the MNFP is a matrix of two axes consisting of a time axis and a node identifier, the MNFP determining unit 131 configures, for example, a matrix having rows or columns respectively for two or more points in time, the matrix having columns or rows in which a value corresponding to one or more firing node identifiers is set to "1" and a value corresponding to a non-firing node identifier is set to "0". Next, the MNFP determining unit 131 sequentially determines MNFPs corresponding to the matrix, out of the one or more MNFPs in the MNFP storage unit 113.

The initial determining part 1311 acquires one or two or more pieces of feature information from the input information accepted by the input accepting unit 121. Next, the initial determining part 1311 determines one or more firing conditions that match the one or more pieces of feature information, and acquires a firing node identifier corresponding to each of the one or more firing conditions.

If the input information is an image, the feature information that is to be acquired is, for example, red "R" constituting a color, green "G" constituting a color, blue "B" constituting a color, a pixel value, or an object identifier that is the result of object recognition performed on the image. If the input information is a speech, the feature information that is to be acquired is, for example, frequency or amplitude. If the input information is a character string, the feature information that is to be acquired is, for example, the class of the character string.

The initial determining part 1311 acquires, for example, one or more pieces of feature information from the input information accepted by the input accepting unit 121. Next, the initial determining part 1311 refers to the firing start point storage unit 112, and acquires one or more firing node identifiers for which the acquired one or more pieces of feature information satisfy a firing condition, from the firing start point storage unit 112.

If the firing condition is associated with a firing probability, the initial determining part 1311 acquires, for example, one or more pieces of feature information from the input information accepted by the input accepting unit 121, determines whether or not each node, of nodes identified with node identifiers corresponding to the firing condition that matches the one or more pieces of feature information, will fire according to the probability indicated by the firing probability, and acquires a firing node identifier for identifying that node only in a case in which it is determined that the node will fire.

The propagating part 1312 acquires one or more connected node identifiers corresponding to each of the one or more firing node identifiers acquired by the initial determining part 1311. Next, the propagating part 1312 acquires one or more connected node identifiers corresponding to each of the one or more connected node identifiers. Next, the propagating part 1312 acquires one or more connected node identifiers connected to each of the one or more connected node identifiers, and the firing is propagated in this manner.

In the case of using the firing probability, the propagating part 1312 acquires one or more connected node identifiers corresponding to each of the one or more firing node identifiers acquired by the initial determining part 1311. The propagating part 1312 acquires an information identifier contained in each of one or more pieces of feature information respectively corresponding to the one or more firing node identifiers acquired by the initial determining part 1311. The propagating part 1312 may acquire an information quantity corresponding to each information identifier. The propagating part 1312 preferably reduces an information quantity contained in feature information corresponding to a firing node identifier acquired by the initial determining part 1311 using a predetermined arithmetic formula (e.g., "×0.9") and acquires the reduced information quantity. Next, the propagating part 1312 determines whether or not the acquired information identifier, the acquired information quantity, or the acquired information identifier and information quantity match a firing condition that is paired with each of the one or more connected node identifiers. The propagating part 1312 acquires, as a firing node identifier, only a connected node identifier that is paired with a firing condition determined as being matched.

If the NN has a propagation probability associated with each of the one or more node identifiers, the propagating part 1312 acquires a connected node identifier corresponding to each of the one or more firing node identifiers acquired by the initial determining part 1311, according to the probability indicated by the propagation probability. If the NN has a propagation probability associated with each of the one or more node identifiers, the propagating part 1312 acquires a connected node identifier corresponding to each of the acquired one or more connected node identifiers, according to the probability indicated by the propagation probability.

If the NN has a propagation probability associated with each of the one or more node identifiers, the propagating part 1312 preferably acquires or does not acquire, as a firing node identifier, a connected node identifier that is paired with a firing condition determined as being matched, according to the probability indicated by the propagation probability.

The MNFP determining part 1313 acquires, in a time series, firing information having one or more firing node identifiers among the one or more firing node identifiers and the one or more connected node identifiers acquired by the initial determining part 1311 and the propagating part 1312. The acquiring information in a time series is acquiring information at two or more points in time. Next, the MNFP determining part 1313 sequentially determines one or more MNFPs corresponding to the time-series firing information, out of the one or more MNFPs in the MNFP storage unit 113. The MNFPs corresponding to the time-series firing information are MNFPs that satisfy a correspondence condition.

The movement determining unit 132 sequentially acquires movement determination information respectively corresponding to the one or more MNFPs determined by the MNFP determining unit 131, from the MNFP storage unit 113. That is to say, the movement determining unit 132 acquires, at each of two or more points in time, movement determination information respectively corresponding to the one or more MNFPs determined by the MNFP determining unit 131.

The muscle determining part 1321 refers to the muscle storage unit 115, and sequentially determines one or more pieces of muscle information associated with each of one or more firing node identifiers specified with the one or more MNFPs determined by the MNFP determining unit 131. That is to say, the muscle determining part 1321 determines, at each of two or more points in time, one or more pieces of muscle information associated with each of one or more firing node identifiers specified with the one or more MNFPs determined by the MNFP determining unit 131. Typically, the one or more firing node identifiers specified with an MNFP are preferably one or more firing node identifiers at the latest point in time contained in the MNFP. Note that the one or more firing node identifiers specified with an MNFP may also be all firing node identifiers at two or more points in time contained in the MNFP.

The intensity acquiring part 1322 acquires an intensity for each of the one or more pieces of muscle information determined by the muscle determining part 1321.

The intensity acquiring part 1322 acquires, for each of the one or more pieces of muscle information determined by the muscle determining part 1321, a firing number, which is the number of firing node identifiers associated with the muscle information, for example. Next, the intensity acquiring part 1322 acquires, for each of the one or more pieces of muscle information determined by the muscle determining part 1321, the maximum power indicated by the muscle information, from the muscle storage unit 115, for example. Next, the intensity acquiring part 1322 sequentially acquires intensities using the firing number and the maximum power, for example. The intensity acquiring part 1322 typically acquires a higher intensity in accordance with an increase in the firing number. The intensity acquiring part 1322 typically acquires a higher intensity in accordance with an increase in the maximum power. The intensity acquiring part 1322 acquires, for example, an intensity using an increasing function in which the firing number and the maximum power are taken as parameters. The arithmetic formula indicating such an increasing function is stored in the storage unit 11. The intensity acquiring part 1322 acquires, for example, an intensity corresponding to the firing number and the maximum power from a correspondence table. The correspondence table is a table having two or more pieces of correspondence information each having the firing number and the maximum power and the intensity. The intensity acquiring part 1322 acquires, for example, an intensity that is paired with the firing number and the maximum power that most closely approximate the firing number and the maximum power, from the correspondence table.

The intensity acquiring part 1322 acquires, for each of the one or more pieces of muscle information determined by the muscle determining part 1321, the maximum power indicated by the muscle information, from the muscle storage unit 115, for example. Next, the intensity acquiring part 1322 sequentially acquires intensities using the maximum power, for example. The intensity acquiring part 1322 typically acquires a higher intensity in accordance with an increase in the maximum power. The intensity acquiring part 1322 acquires a percentage (%) of a force that is used by the muscle based on the firing number, and multiplies the percentage and the maximum power, thereby calculating an intensity, for example. It is preferable that the intensity acquiring part 1322 calculates, for example, an attenuation rate for specifying a change in the intensity over time using, for example, a hill type model, and uses the attenuation rate to acquire time-series intensities such that the intensity approaches the maximum power or to acquire time-series intensities such that the intensity changes from the maximum power to 0.

For example, each time the muscle determining part 1321 determines one or more pieces of muscle information, the intensity acquiring part 1322 acquires an intensity corresponding to each of the one or more pieces of muscle information. As a result, the intensity acquiring part 1322 sequentially acquires intensities respectively corresponding to the one or more pieces of muscle information.

Through the above-described processing, the intensity acquiring part 1322 sequentially acquires one or two or more pieces of movement muscle information. The movement muscle information is a pair of a muscle identifier and an intensity.

The angle acquiring part 1323 refers to the joint storage unit 116, and sequentially acquires angles of joints respectively identified with one or more joint identifiers associated with muscle identifiers contained in the one or more pieces of muscle information determined by the muscle determining part 1321, using the one or more pieces of movement muscle information acquired by the intensity acquiring part 1322.

The angle acquiring part 1323 calculates, for each of the one or more joints, the angle of the joint, using the intensity corresponding to one or more muscle identifiers that are paired with a joint identifier of the joint. The angle acquiring part 1323 determines, for example, a direction and an angle of bending of the joint using a physical calculation to calculate torque.

The angle acquiring part 1323 sequentially acquires, for example, a joint-angle set, which is a set of pairs of a joint identifier and an angle. The joint-angle set may also be a set of pairs of an angle and a joint position.

The moving unit 133 moves the movable object 2 sequentially using the one or more pieces of movement determination information acquired by the movement determining unit 132.

The moving unit 133 sequentially moves the movable object 2, for example, based on one or more pieces of movement muscle information, each of which is a pair of a muscle identifier contained in each of the one or more pieces of muscle information determined by the muscle determining part 1321 and an intensity acquired by the intensity acquiring part 1322.

The moving unit 133 outputs, for example, the angles of the respective one or more joints determined by the angle acquiring part 1323 to the movable object 2, thereby moving the movable object 2. That is to say, the moving unit 133 moves the movable object 2, for example, sequentially using the joint-angle set acquired the angle acquiring part 1323.

If the movable object 2 is an avatar, for example, the moving unit 133 configures an avatar whose joints respectively specified with the joint positions of the one or more joints have been bent according to the angles determined by the angle acquiring part 1323, using the avatar information, and outputs the avatar.

If the movable object 2 is a robot, for example, the moving unit 133 sends an instruction to the robot to bend its joints respectively specified with the joint positions of the one or more joints, according to the angles determined by the angle acquiring part 1323, thereby moving the robot.

The muscle changing unit 134 performs change processing for increasing a maximum power that is paired with a muscle identifier determined by the muscle determining part 1321, in a case in which the muscle identifier satisfies a predetermined increase condition.

The increase condition is, for example, that the muscle determining part 1321 has determined a muscle identifier, that the number of times that the muscle determining part 1321 has determined a muscle identifier is greater than or equal to a threshold value or is greater than the threshold value, that the number of times in a unit time that the muscle determining part 1321 has determined a muscle identifier is greater than or equal to a threshold value or is greater than the threshold value, or the like. In the change processing for increasing the maximum power, the degree to which the maximum power is increased is not limited. For example, if the increase condition is satisfied, the muscle changing unit 134 increases the maximum power that is paired with the muscle identifier by the number (e.g., "1") corresponding to the threshold value. For example, if the increase condition is satisfied, the muscle changing unit 134 increases the maximum power that is paired with the muscle identifier by the percentage (e.g., "10%") corresponding to the threshold value.

The muscle changing unit 134 performs change processing for decreasing a maximum power that is paired with a muscle identifier not determined by the muscle determining part 1321, in a case in which the muscle identifier satisfies a predetermined decrease condition.

The decrease condition is, for example, that the muscle identifier is a muscle identifier that has not been determined by the muscle determining part 1321 for a period of time whose length is greater than or equal to a threshold time or is greater than the threshold time. In the change processing for decreasing the maximum power, the degree to which the maximum power is decreased is not limited. For example, if the decrease condition is satisfied, the muscle changing unit 134 decreases the maximum power that is paired with the muscle identifier by the number (e.g., "1") corresponding to the threshold value. For example, if the decrease condition is satisfied, the muscle changing unit 134 decreases the maximum power that is paired with the muscle identifier by the percentage (e.g., "15%") corresponding to the threshold value.

The learning unit 135 acquires an MNFP in a case in which the input accepting unit 121 accepts input information. The learning unit 135 accepts movement determination information. The learning unit 135 accumulates the MNFP in the MNFP storage unit 113 in association with the accepted movement determination information. This processing is referred to as learning processing.

The storage unit 11, the NN storage unit 111, the firing start point storage unit 112, the MNFP storage unit 113, the avatar storage unit 114, the muscle storage unit 115, and the joint storage unit 116 are preferably non-volatile recording media, but may alternately be realized by volatile recording media.

There is no limitation on the procedure in which information is stored in the storage unit 11 and the like. For example, information may be stored in the storage unit 11 and the like via a recording medium, information transmitted via a communication line or the like may be stored in the storage unit 11 and the like, or information input via an input device may be stored in the storage unit 11 and the like.

The accepting unit 12 and the input accepting unit 121 may be realized by a device driver for an input part such as a touch screen or a keyboard, control software for a menu screen, or the like. Note that the accepting unit 12 and the like may be realized by wireless or wired communication parts.

The processing unit 13, the MNFP determining unit 131, the movement determining unit 132, the moving unit 133, the muscle changing unit 134, the learning unit 135, the initial determining part 1311, the propagating part 1312, the MNFP determining part 1313, the muscle determining part 1321, the intensity acquiring part 1322, and the angle acquiring part 1323 may be typically realized by processors, memories, or the like. Typically, the processing procedure of the processing unit 13 and the like is realized by software, and the software is stored in a recording medium such as a ROM. However, the processing procedure may be realized by hardware (dedicated circuits). The processors are, for example, CPUs, MPUs, GPUs, or the like, and there is no limitation on the type thereof.

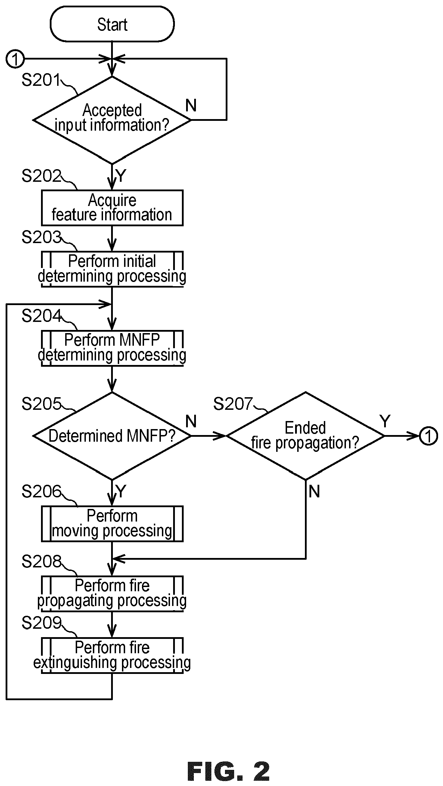

Next, an operation example of the information processing apparatus 1 will be described with reference to the flowchart in FIG. 2.

(Step S201) The input accepting unit 121 determines whether or not it has accepted input information. If it has accepted input information, the procedure advances to step S202, or otherwise the procedure returns to step S201.

(Step S202) The initial determining part 1311 acquires one or more pieces of feature information from the input information accepted in step S201. The technique for acquiring one or more pieces of feature information from input information such as images, speeches, or character strings is a known technique.

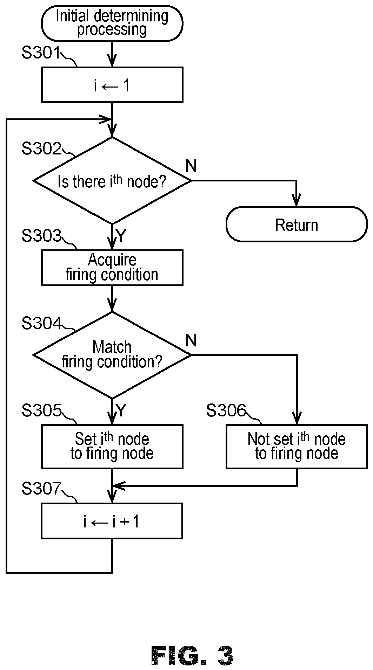

(Step S203) The initial determining part 1311 performs initial determining processing. An example of the initial determining processing will be described with reference to the flowchart in FIG. 3. The initial determining processing is processing for determining a node that fires first, using the one or more pieces of feature information acquired in step S202.

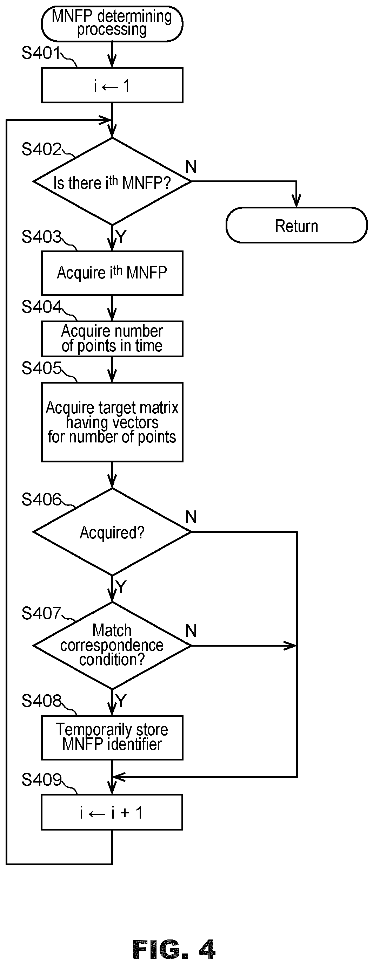

(Step S204) The MNFP determining part 1313 performs MNFP determining processing. An example of the MNFP determining processing will be described with reference to the flowchart in FIG. 4. The MNFP determining processing is processing for determining an MNFP corresponding to one or more time-series firing node identifiers.

(Step S205) The movement determining unit 132 determines whether or not one or more MNFPs have been determined in step S204. If MNFPs have been determined, the procedure advances to step S206, or otherwise the procedure advances to step S207.

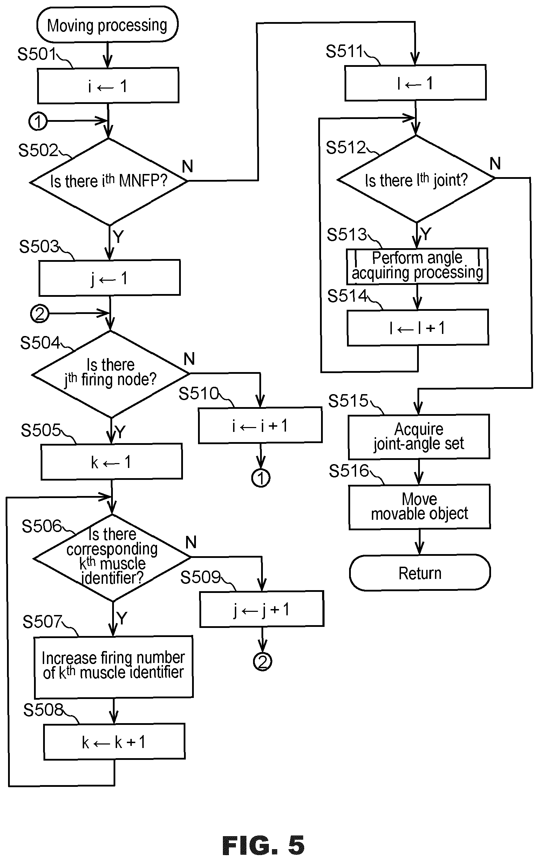

(Step S206) The movement determining unit 132 and the like perform moving processing according to the determined MNFPs. An example of the moving processing will be described with reference to the flowchart in FIG. 5.

(Step S207) The propagating part 1312 determines whether or not the fire propagation has been ended. If the fire propagation has been ended, the procedure returns to step S201, or otherwise the procedure advances to step S208.

The propagating part 1312 determines that the fire propagation has been ended, for example, in a case in which there is no connected node to any of the one or more nodes that fired at the immediately preceding point in time. The propagating part 1312 determines that the fire propagation has been ended, for example, in a case in which a predetermined time has elapsed since the input information was accepted.

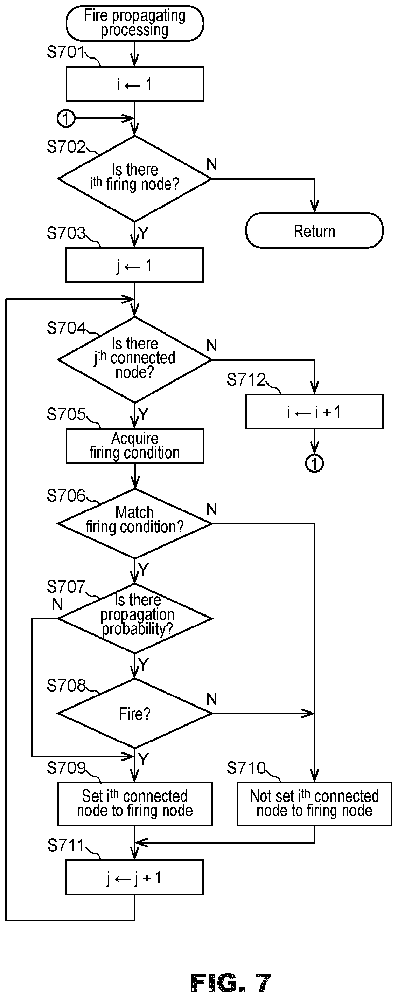

(Step S208) The propagating part 1312 performs fire propagating processing. The procedure returns to step S204. An example of the fire propagating processing will be described with reference to the flowchart in FIG. 7. The fire propagating processing is processing for determining a node that fires at the next point in time.

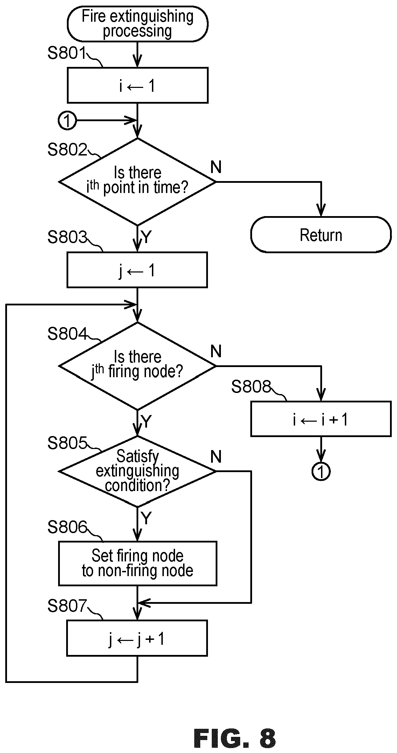

(Step S209) The processing unit 13 performs fire extinguishing processing. An example of the fire extinguishing processing will be described with reference to the flowchart in FIG. 8. The fire extinguishing processing is processing for changing a firing state of a node to a non-firing state.

In the flowchart in FIG. 2, the processing ends at power off or at an interruption of termination processing.

Next, an example of the initial determining processing in step S203 will be described with reference to the flowchart in FIG. 3.

(Step S301) The initial determining part 1311 substitutes 1 for a counter i.

(Step S302) The initial determining part 1311 determines whether or not there is an i^{th} node among the candidate nodes to fire at the initial point in time. If there is an i^{th} node, the procedure advances to step S303, or otherwise the procedure returns to the upper-level processing.

The initial determining part 1311 determines, for example, whether or not there is an i^{th} node identifier among the node identifiers contained in the one or more pieces of firing start point information stored in the firing start point storage unit 112. Alternatively, the initial determining part 1311 determines, for example, whether or not there is an i^{th} node identifier in the NNs in the NN storage unit 111. Alternatively, the initial determining part 1311 determines, for example, whether or not there is an i^{th} node identifier that is in the NNs in the NN storage unit 111 and that is paired with firing information using the feature information.

(Step S303) The initial determining part 1311 acquires a firing condition that is paired with a node identifier of the i^{th} node, from the firing start point storage unit 112 or the NN storage unit 111.

(Step S304) The initial determining part 1311 determines whether or not the firing condition acquired in step S303 is satisfied by the acquired one or more pieces of feature information. If the firing condition is satisfied, the procedure advances to step S305, or otherwise the procedure advances to step S306.

(Step S305) The initial determining part 1311 performs processing for setting the i^{th} node to a firing node, in association with the current point in time. The processing for setting the i^{th} node to a firing node is, for example, processing for writing "1" to an element of a vector associated with the current point in time, the element corresponding to the node identifier of the i^{th} node. The vector is stored in, for example, the firing information storage unit 117.

(Step S306) The initial determining part 1311 performs processing for not setting the i^{th} node to a firing node, in association with the current point in time. The processing for not setting the i^{th} node to a firing node is, for example, processing for writing "0" to an element of a vector associated with the current point in time, the element corresponding to the node identifier of the i^{th} node. The vector is stored in, for example, the firing information storage unit 117.

(Step S307) The initial determining part 1311 increments the counter i by 1. The procedure returns to step S302.

Through the processing in the flowchart in FIG. 3, for example, it is possible to acquire a vector for specifying a firing node at the initial point in time.

Next, an example of the MNFP determining processing in step S204 will be described with reference to the flowchart in FIG. 4.

(Step S401) The MNFP determining part 1313 substitutes 1 for a counter i.

(Step S402) The MNFP determining part 1313 determines whether or not there is an i^{th} MNFP in the MNFP storage unit 113. If there is an i^{th} MNFP, the procedure advances to step S403, or otherwise the procedure returns to the upper-level processing.

(Step S403) The MNFP determining part 1313 acquires the i^{th} MNFP from the MNFP storage unit 113.

(Step S404) The MNFP determining part 1313 acquires the number of points in time of the i^{th} MNFP acquired in step S403. The number of points in time is, for example, the number of rows or the number of columns constituting a matrix of the i^{th} MNFP.

(Step S405) The MNFP determining part 1313 acquires a matrix having firing vectors for the number of points in time acquired in step S404, starting from the latest point in time and going back in time. This matrix is called a target matrix because it is a target to be compared with the MNFP. The target matrix is information for specifying a firing node that fired based on the input information, and is time-series information. The MNFP determining part 1313 acquires, for example, a target matrix from the firing information storage unit 117.

(Step S406) The MNFP determining part 1313 determines whether or not it has acquired a target matrix having firing vectors for the number of points in time in step S405. If it has acquired a target matrix, the procedure advances to step S407, or otherwise the procedure advances to step S409.

(Step S407) The MNFP determining part 1313 determines whether or not the correspondence condition is satisfied by the target matrix and the i^{th} MNFP. If the correspondence condition is satisfied, the procedure advances to step S408, or otherwise the procedure advances to step S409. The correspondence condition is, for example, that the target matrix and the i^{th} MNFP match each other, or that the similarity between the target matrix and the i^{th} MNFP is greater than or equal to a threshold value or is greater than the threshold value.

(Step S408) The MNFP determining part 1313 temporarily stores an MNFP identifier for identifying the i^{th} MNFP in an unshown buffer.

(Step S409) The MNFP determining part 1313 increments the counter i by 1. The procedure returns to step S402.

Next, an example of the moving processing in step S206 will be described with reference to the flowchart in FIG. 5.

(Step S501) The movement determining unit 132 substitutes 1 for a counter i.

(Step S502) The movement determining unit 132 determines whether or not there is an i^{th} MNFP identifier accumulated in the buffer in step S408. If there is an i^{th} MNFP identifier, the procedure advances to step S503, or otherwise the procedure advances to step S511.

(Step S503) The movement determining unit 132 substitutes 1 for a counter j.

(Step S504) The movement determining unit 132 determines whether or not there is a j^{th} firing node identifier contained in the MNFP identified with the i^{th} MNFP identifier. If there is a j^{th} firing node identifier, the procedure advances to step S505, or otherwise the procedure advances to step S510. It is preferable that the j^{th} firing node identifier in this case is a firing node identifier at the latest point in time (the current point in time) among the firing node identifiers contained in the MNFP.

(Step S505) The movement determining unit 132 substitutes 1 for a counter k.

(Step S506) The movement determining unit 132 determines whether or not there is a k^{th} muscle identifier among the muscle identifiers corresponding to the j^{th} firing node identifier. If there is a k^{th} muscle identifier, the procedure advances to step S507, or otherwise the procedure advances to step S509.

(Step S507) The movement determining unit 132 increases a firing number, which is the number of firing nodes, corresponding to the k^{th} muscle identifier (the firing number of the k^{th} muscle). The amount to be increased is, for example, 1, but there is no limitation to this.

(Step S508) The movement determining unit 132 increments the counter k by 1. The procedure returns to step S506.

(Step S509) The movement determining unit 132 increments the counter j by 1. The procedure returns to step S504.

(Step S510) The movement determining unit 132 increments the counter i by 1. The procedure returns to step S502.

(Step S511) The movement determining unit 132 substitutes 1 for a counter 1.

(Step S512) The movement determining unit 132 determines whether or not there is an l^{th} joint. If there is an l^{th} joint, the procedure advances to step S513, or otherwise the procedure advances to step S515.

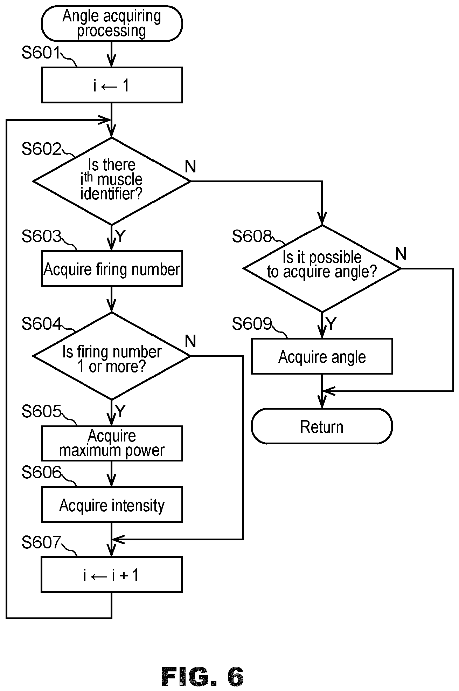

(Step S513) The angle acquiring part 1323 performs processing for acquiring an angle of the l^{th} joint. An example of the angle acquiring processing will be described with reference to the flowchart in FIG. 6.

(Step S514) The movement determining unit 132 increments the counter 1 by 1. The procedure returns to step S512.

(Step S515) The moving unit 133 configures a joint-angle set using the angle of the joint determined in step S513.

(Step S516) The moving unit 133 moves the movable object 2 using the joint-angle set acquired in step S515. The procedure returns to the upper-level processing.

The moving unit 133 configures an avatar, for example, such that the angle of each joint is as indicated by the joint-angle set, using the avatar information in the avatar storage unit 114, and outputs the avatar. The moving unit 133 moves the robot, for example, such that the angle of each joint is as indicated by the joint-angle set.

Next, an example of the angle acquiring processing in step S513 will be described with reference to the flowchart in FIG. 6.

(Step S601) The movement determining unit 1322 substitutes 1 for a counter i.

(Step S602) The muscle determining part 1321 refers to the joint storage unit 116, and determines whether or not there is an i^{th} muscle identifier that is paired with a joint identifier of the l^{th} joint in step S512. If there is an i^{th} muscle identifier, the procedure advances to step S603, or otherwise the procedure advances to step S607.

(Step S603) The intensity acquiring part 1322 acquires the firing number that is paired with the i^{th} muscle identifier.

(Step S604) The intensity acquiring part 1322 determines whether or not the firing number acquired in step S603 is one or more. If the firing number is one or more, the procedure advances to step S605, or otherwise, that is, if the firing number is 0 or the firing number cannot be acquired, the procedure advances to step S607.

(Step S605) The intensity acquiring part 1322 acquires a maximum power that is paired with the i^{th} muscle identifier, from the muscle storage unit 115.

(Step S606) The intensity acquiring part 1322 acquires an intensity of the muscle identified with the i^{th} muscle identifier, using the firing number acquired in step S603 and the maximum power acquired in step S605.

(Step S607) The movement determining unit 132 increments the counter i by 1. The procedure returns to step S602.

(Step S608) The angle acquiring part 1323 determines whether or not it is possible to acquire the angle of the l^{th} joint in step S512 using the intensity of each of the one or two or more muscles acquired in step S606. If it is possible to acquire the angle, the procedure advances to step S609, or otherwise the procedure returns to the upper-level processing.

The case in which it is not possible to acquire the angle is a case in which the intensity cannot be acquired in step S606.

(Step S609) The angle acquiring part 1323 acquires the angle of the l^{th} joint in step S512. The procedure returns to the upper-level processing.

In the flowchart in FIG. 6, the angle acquiring part 1323 typically accumulates the joint identifier and the angle in an unshown buffer in association with each other.

Next, an example of the fire propagating processing in step S208 will be described with reference to the flowchart in FIG. 7.

(Step S701) The propagating part 1312 substitutes 1 for a counter i.

(Step S702) The propagating part 1312 determines whether or not there is an i^{th} firing node that fired at the immediately preceding point in time. If there is an i^{th} firing node, the procedure advances to step S703, or otherwise the procedure returns to the upper-level processing.

(Step S703) The propagating part 1312 substitutes 1 for a counter j.

(Step S704) The propagating part 1312 determines whether or not there is a j^{th} connected node corresponding to the i^{th} firing node. If there is a j^{th} connected node, the procedure advances to step S705, or otherwise the procedure advances to step S712.

The propagating part 1312 typically refers to the NN storage unit 111, and determines whether or not there is a j^{th} connected node identifier that is paired with a node identifier for identifying the i^{th} firing node. If there is a j^{th} connected node identifier, the procedure advances to step S705, or otherwise the procedure advances to step S712.

(Step S705) The propagating part 1312 acquires a firing condition that is paired with the j^{th} connected node identifier, from the NN storage unit 111.

(Step S706) The propagating part 1312 acquires feature information corresponding to the i^{th} firing node. The propagating part 1312 may acquire feature information containing an information quantity from which the information quantity contained in the feature information corresponding to the i^{th} firing node has been reduced. Next, the propagating part 1312 determines whether or not the firing condition that is paired with the j^{th} connected node identifier is satisfied by the acquired feature information. If the firing condition is satisfied, the procedure advances to step S707, or otherwise the procedure advances to step S710. The acquired feature information is, for example, an information quantity, an information identifier, or an information quantity and an information identifier.

(Step S707) The propagating part 1312 determines whether or not there is a propagation probability that is paired with the j^{th} connected node identifier, in the NN storage unit 111. If there is a propagation probability, the procedure advances to step S708, or otherwise the procedure advances to step S709.

(Step S708) The propagating part 1312 determines whether or not the node identified with the j^{th} connected node identifier fires according to the propagation probability. If the node fires, the procedure advances to step S709, or otherwise the procedure advances to step S710.

(Step S709) The propagating part 1312 sets the node identified with the j^{th} connected node identifier to a firing node.

(Step S710) The propagating part 1312 does not set the node identified with the j^{th} connected node identifier a firing node.

(Step S711) The propagating part 1312 increments the counter j by 1. The procedure returns to step S704.

(Step S712) The propagating part 1312 increments the counter i by 1. The procedure returns to step S702.

In step S706 in FIG. 7, the propagating part 1312 determines whether or not the firing condition is satisfied by the acquired feature information. However, in step S706, if the firing condition is satisfied, the propagating part 1312 may determine whether the procedure is to advance to step S707 or to step S710 based on the firing probability.

Next, an example of the fire extinguishing processing in step S209 will be described with reference to the flowchart in FIG. 8.

(Step S801) The processing unit 13 substitutes 1 for a counter i.

(Step S802) The processing unit 13 determines whether or not there is firing information at an i^{th} point in time, which is firing information stored in the firing information storage unit 117 and is firing information corresponding to at least one or more firing node identifiers. If there is firing information at an i^{th} point in time, the procedure advances to step S803, or otherwise the procedure returns to the upper-level processing.

(Step S803) The processing unit 13 substitutes 1 for a counter j.

(Step S804) The processing unit 13 determines whether or not there is a j^{th} firing node among the firing nodes specified with the firing information at the i^{th} point in time. If there is a j^{th} firing node, the procedure advances to step S805, or otherwise the procedure advances to step S808.

(Step S805) The processing unit 13 determines whether or not the j^{th} firing node at the i^{th} point in time satisfies the extinguishing condition. If the j^{th} firing node satisfies the extinguishing condition, the procedure advances to step S806, or otherwise the procedure advances to step S807.

(Step S806) The processing unit 13 sets the firing node at the i^{th} point in time to a non-firing node.

(Step S807) The processing unit 13 increments the counter j by 1. The procedure returns to step S804.

(Step S808) The processing unit 13 increments the counter i by 1. The procedure returns to step S802.

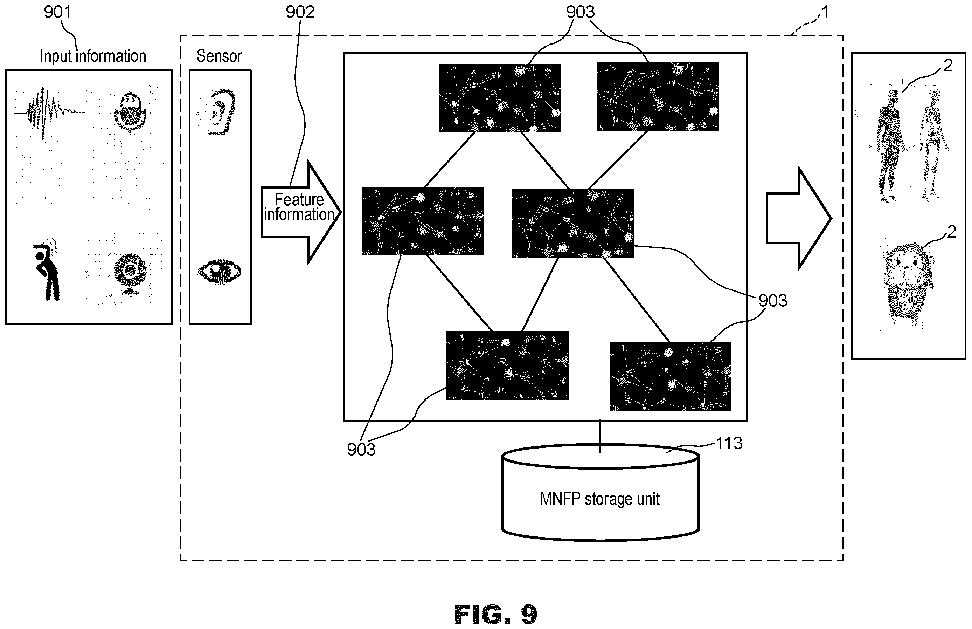

Hereinafter, a specific operation example of the movement system A in this embodiment will be described with reference to the schematic diagram of the movement system Ain FIG. 9.

The input accepting unit 121 of the information processing apparatus 1 accepts input information 901. The input information 901 is, for example, a speech or an image.

The initial determining part 1311 of the information processing apparatus 1 senses the input information 901, thereby acquiring one or more pieces of feature information (902) , for example. The MNFP determining unit 131 applies an NN (903) in the NN storage unit 111 to the one or more pieces of feature information, thereby sequentially determining a set of one or more firing nodes. The MNFP determining unit 131 configures time-series firing information. Next, the MNFP determining unit 131 sequentially determines one or more MNFPs in the MNFP storage unit 113, using the time-series firing information. The moving unit 133 sequentially acquires movement determination information respectively corresponding to the sequentially determined one or more MNFPs. Next, the moving unit 133 sequentially moves the movable object 2 sequentially using the acquired one or more pieces of movement determination information. In FIG. 9, six NNs (903) are linked.

More specifically, for example, the following information is stored in the storage unit 11 of the information processing apparatus 1.

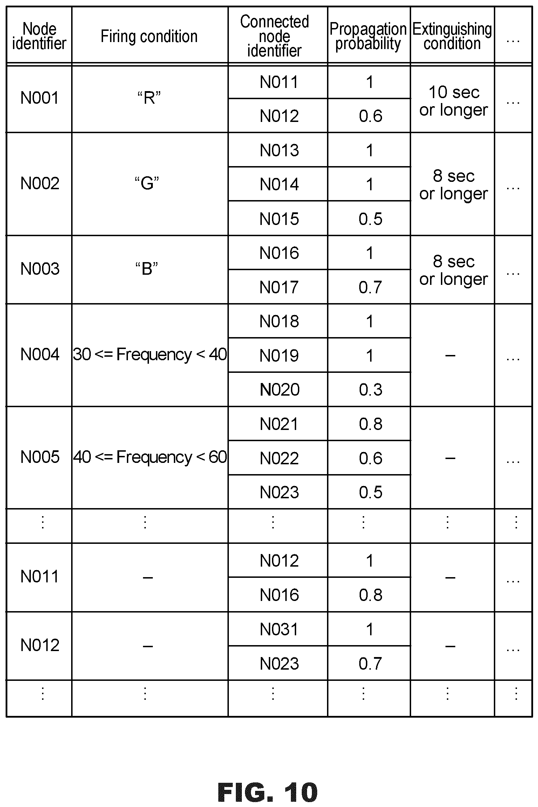

An NN management table shown in FIG. 10 is stored in the NN storage unit 111. The NN management table is a table for managing NNs. The NN management table is a table for managing one or more pieces of node information constituting an NN. The node information in this case has "node identifier", "firing condition", "connected node identifier", "propagation probability", and "extinguishing condition". If "extinguishing condition" is "-", a default extinguishing condition is used as the extinguishing condition for the corresponding node. The default extinguishing condition is, for example, that at least 3 seconds have elapsed since firing.

It is assumed that a set of firing start point information "N001, N002, N003, N004, N005, ..." is stored in the firing start point storage unit 112.

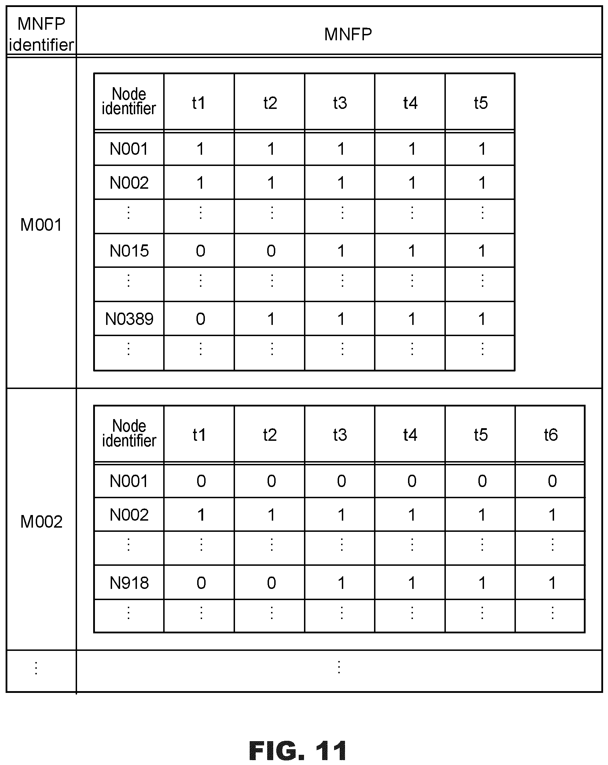

An MNFP management table shown in FIG. 11 is stored in the MNFP storage unit 113. The MNFP management table manages two or more records each having an MNFP identifier and an MNFP. The MNFP in this case is a matrix of two axes consisting of a node identifier and a time. The smaller the number of the time "t1", "t2", "t3", "t4", "t5", the earlier (older) the time. The MNFP with the MNFP identifier "M01" in FIG. 11 shows that, at the time "t1", two nodes identified with "N001" and "N002" are firing nodes and nodes identified with "N015" and "N389" are non-firing nodes.

It is assumed that avatar information for configuring an avatar of the movable object 2 is stored in the avatar storage unit 114.

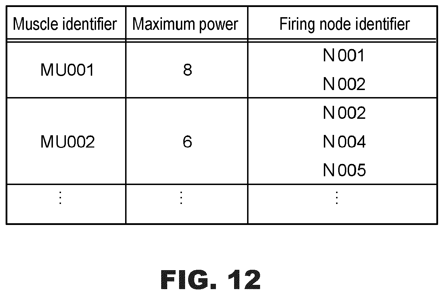

A muscle management table shown in FIG. 12 is stored in the muscle storage unit 115. The muscle management table manages one or more pieces of muscle information. The muscle information in this case has "muscle identifier", "maximum power", and "firing node identifier". That is to say, the muscle information is information on a muscle that moves in a case in which the node fires. It is shown that the muscle identified with the muscle identifier "MU001" moves in a case in which a node identified with the node identifier "N001" or "N002" is in a firing state. The muscle identified with the muscle identifier "MU001" has a maximum power of "8".

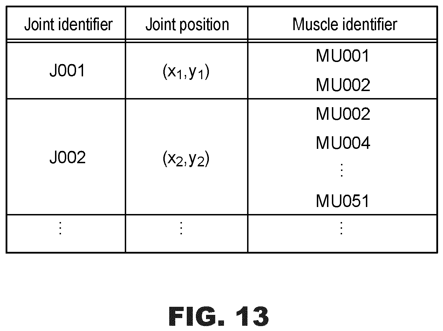

A joint management table shown in FIG. 13 is stored in the joint storage unit 116. The joint management table manages one or more pieces of joint information. The joint information in this case has "joint identifier", "joint position", and "muscle identifier". In this case, "joint position" is coordinate values indicating the center of gravity of a joint.

In FIG. 13, it is shown that the joint identified with the joint identifier "J001" is a joint that moves according to the intensity of a muscle identified with each of the muscle identifiers "MU001" and "MU002".

In this situation, it is assumed that the information processing apparatus 1 has accepted input information (e.g., an image).

Next, the initial determining part 1311 acquires two or more pieces of feature information (e.g., "R", "G", and "B") from the accepted input information.

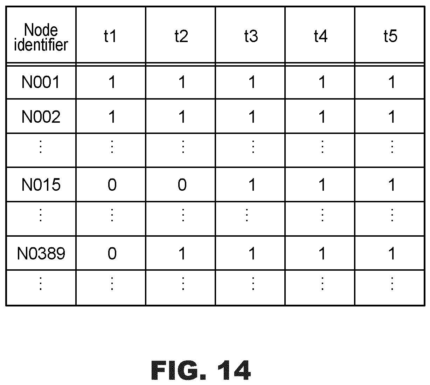

Next, the initial determining part 1311 performs the initial determining processing as follows. That is to say, the initial determining part 1311 refers to a set of firing start point information "N001, N002, N003, N004, N005, ..." in the firing start point storage unit 112 and the NN management table (FIG. 10), and acquires node identifiers "N001, N002, N003, ..." of nodes that fire for the two or more pieces of feature information (e.g., "R", "G", and "B"). It is assumed that a vector (1, 1, 1, 0, 0, ..., 0, ..., 0, ...) constituting the firing node identifiers is accumulated in the firing information storage unit 117 in association with the time "t1". This information is information in the column corresponding to "t1" in FIG. 14.

Next, the MNFP determining part 1313 performs the MNFP determining processing as follows. That is to say, the MNFP determining part 1313 refers to FIG. 11, and determines that the firing information vector (1, 1, 1, 0, 0, ..., 0, ..., 0, ...) corresponding to "t1" in FIG. 14 does not match (in this case, fully match) any of the MNFPs in the MNFP management table.

Next, the propagating part 1312 performs the propagating processing, for example, as follows. That is to say, the propagating part 1312 acquires a connected node identifier that is paired with an identifier ("N001", "N002", "N003") of each firing node that fired at the time "t1" (e.g., "N011" and "N012" that are paired with "N001", "N013", "N014", and "N015" that are paired with "N002", "N016" and "N017" that are paired with "N003", etc.). Next, the propagating part 1312 acquires a propagation probability that is paired with each connected node identifier, and, if the propagation probability is less than 1, draws lots according to the propagation probability and determines whether or not the connected node identifier becomes a firing node identifier. The propagating part 1312 determines that a connected node identifier that is paired with the propagation probability "1" becomes a firing node identifier. The propagating part 1312 acquires a vector (1, 1, ..., 0, ..., 1, ...), which is a set of firing node identifiers, in association with the time "t2". The propagating part 1312 adds the vector to the firing information storage unit 117 in association with the time "t2" (refer to the column corresponding to "t2" in FIG. 14).

If there is a firing condition that is paired with the connected node identifier, as described above, the propagating part 1312 determines whether or not the connected node identifier becomes a firing node identifier, only in a case in which the firing condition is satisfied.

Next, it is assumed that the MNFP determining part 1313 determines that there is no MNFP that matches a matrix with two columns of the times "t1" and "t2", in the MNFP management table (FIG. 11).

Next, it is assumed that the propagating part 1312 has further proceeded with the propagating processing. It is assumed that a set of firing information shown in FIG. 14 is stored in the firing information storage unit 117.

Next, the MNFP determining part 1313 determines that the set (matrix) of firing information shown in FIG. 14 corresponds to (in this case, fully matches) the MNFP of "M001" in the MNFP management table (FIG. 11). That is to say, the MNFP determining part 1313 determines the MNFP identifier "M001".

Next, the muscle determining part 1321 acquires firing node identifiers ("N001", "N002", ..., "N015", ..., "N389" ...) at the most recent point in time "t5" of the MNFP identified with the MNFP identifier "M001".

Next, it is assumed that the muscle determining part 1321 refers to the muscle management table (FIG. 12), and acquires muscle identifiers ("MU001", "MU002" ...) that are paired with each of the acquired firing node identifiers.

Next, the intensity acquiring part 1322 refers to the column "t5" in FIG. 14, and acquires, for each acquired muscle identifier, a firing number, which is the number of nodes that are firing among the firing node identifiers that are paired with the muscle identifier. For example, the intensity acquiring part 1322 acquires the firing number "2" for the muscle identifier "MU001", and acquires the firing number "1" for the muscle identifier "MU002".

The intensity acquiring part 1322 acquires, for each acquired muscle identifier, a maximum power that is paired with the muscle identifier from the muscle management table (FIG. 12). Next, the intensity acquiring part 1322 acquires, for each acquired muscle identifier, an intensity using the firing number and the maximum power.

Next, the angle acquiring part 1323 acquires one or more joint identifiers that are paired with the muscle identifier of the muscle whose intensity has been acquired, from the joint management table (FIG. 13). The angle acquiring part 1323 acquires, for each acquired joint identifier, an angle of the joint using the intensities of the muscles respectively identified with two or more muscle identifiers that are paired with the joint identifier. The angle acquiring part 1323 acquires, for each joint identifier, a joint position that is paired with the joint identifier, from the joint management table (FIG. 13). Through the above-described processing, the angle acquiring part 1323 acquires (angle, joint position) for each joint that moves. A set of (angle, joint position) of one or more joints that move is a joint-angle set.

Next, the moving unit 133 acquires avatar information in the avatar storage unit 114. Next, the moving unit 133 deforms the avatar information such that the angle of each joint is as indicated by the acquired joint-angle set, thereby moving the avatar that is the movable object 2.

Thereafter, the operation of the information processing apparatus 1 continues according to the processing described in the flowcharts in FIG. 2 and the like.

As described above, according to this embodiment, it is possible to appropriately simulate a movement according to cognition of a living organism such as a person, using MNFPs.

In particular, according to this embodiment, it is possible to appropriately simulate a movement of a muscle according to cognition of a living organism such as a person.

Furthermore, according to this embodiment, it is possible to appropriately simulate a movement of a joint according to cognition of a living organism such as a person.

Moreover, according to this embodiment, it is possible to simulate a movement of a joint according to cognition of a living organism such as a person, using an avatar.

In the specific example of this embodiment, the movable object 2 was an avatar, but other types of movable object 2 such as robots can also be used. In a robot, once the joints and their angles are determined, the movement of the robot is determined.

The processing in this embodiment may be realized by software. The software may be distributed by software downloads or the like. Furthermore, the software may be distributed in a form where the software is stored in a recording medium such as a CD-ROM. The same applies to other embodiments in this specification. The software that realizes the information processing apparatus 1 in this embodiment is the following sort of program. Specifically, this program is a program for causing a computer capable of accessing: a neural network (NN) storage unit in which a neural network having two or more nodes each identified with a node identifier is stored; and a motor neuron firing pattern (MNFP) storage unit in which one or more pieces of control information are stored, each of which is information containing one or two or more MNFPs for specifying one or more firing nodes at each of two or more points in time, and is information corresponding to movement determination information for determining a movement of a movable object, to function as: an input accepting unit that accepts input information; an MNFP determining unit that applies the input information to the neural network, thereby acquiring, in a time series, one or more firing node identifiers of the two or more nodes included in the neural network, and sequentially determines one or more MNFPs corresponding to the one or more time-series firing node identifiers, out of the one or more MNFPs in the MNFP storage unit; a movement determining unit that sequentially acquires movement determination information respectively corresponding to the one or more MNFPs determined by the MNFP determining unit; and a moving unit that moves the movable object sequentially using the one or more pieces of movement determination information acquired by the movement determining unit.

### Embodiment 2

This embodiment is different from Embodiment 1 in that the movable object is an object with no joint. The movable object is, for example, a face. In this embodiment, a movement of a muscle corresponding to the movable object is simulated.

In this embodiment, an information processing apparatus that, in a case in which the muscle that moves is a muscle of a face, acquires an intensity of stretching and contraction for each mesh of the face and uses the intensity for each mesh to change the face.

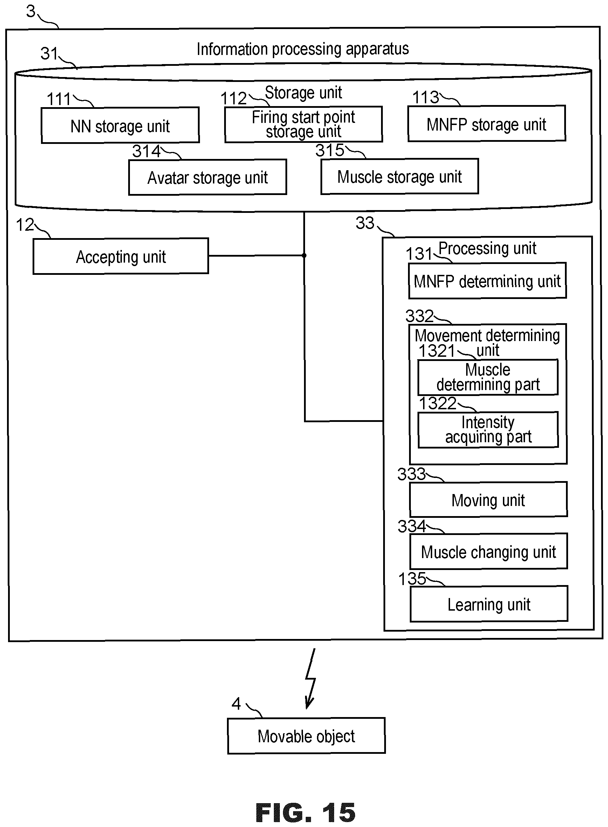

FIG. 15 is a block diagram of a movement system B in this embodiment. The movement system B includes an information processing apparatus 3 and a movable object 4. The information processing apparatus 3 may be configured to include the movable object 4.

The movable object 4 is an object that moves. The movable object 4 is, for example, an avatar or a robot, but the type thereof is not limited.

The information processing apparatus 3 includes a storage unit 31, an accepting unit 12, and a processing unit 33. The storage unit 31 includes an NN storage unit 111, a firing start point storage unit 112, an MNFP storage unit 113, an avatar storage unit 314, and a muscle storage unit 315. The processing unit 33 includes an MNFP determining unit 131, a movement determining unit 332, a moving unit 333, a muscle changing unit 334, and a learning unit 135. The movement determining unit 332 includes a muscle determining part 1321 and an intensity acquiring part 1322.

Various types of information are stored in the storage unit 31 constituting the information processing apparatus 3. The various types of information are, for example, a neural network (NN), firing start point information, an MNFP, avatar information, or muscle information.

Avatar information for outputting an avatar is stored in the avatar storage unit 314. The avatar information in this case does not have to indicate a joint. The avatar information is, for example, information for configuring a face of a living organism such as a person. As described above, the data structure of the avatar information is not limited. Note that the avatar information typically has model information. The model information is information for configuring the avatar display. The model information has, for example, mesh information.

Two or more pieces of muscle information are stored in the muscle storage unit 315. The muscle information in this case is information on a mesh that moves in a case in which one or two or more nodes fire. The muscle information is information associated with one or two or more firing node identifiers. The muscle information has, for example, a muscle identifier. The muscle information has, for example, a muscle identifier, a maximum power, and a mesh position. The mesh is a partial region of a face of an avatar. The muscle identifier in this case is information for identifying a mesh, which is a partial region of a face of an avatar. The muscle identifier in this case may also be said to be a mesh identifier. The mesh position is information for specifying a position of a mesh.

The processing unit 33 performs various types of processing. The various types of processing are, for example, processing that is performed by the movement determining unit 332, the moving unit 333, and the muscle changing unit 334.

The movement determining unit 332 sequentially acquires movement determination information respectively corresponding to the one or more MNFPs determined by the MNFP determining unit 131. The movement determining unit 332 typically performs processing that is performed by the muscle determining part 1321 and the intensity acquiring part 1322.

The moving unit 333 moves the movable object 4 sequentially using the one or more pieces of movement determination information acquired by the movement determining unit 332.

The moving unit 333 sequentially moves the movable object 4 based on one or more pieces of movement muscle information, each of which is a pair of a muscle identifier contained in each of the one or more pieces of muscle information determined by the muscle determining part 1321 and an intensity acquired by the intensity acquiring part 1322.

the moving unit 333 sequentially stretches and contracts meshes identified with muscle identifiers contained in the muscle information determined by the muscle determining part 1321.

The muscle changing unit 334 performs change processing for increasing a maximum power that is paired with a muscle identifier determined by the muscle determining part 1321, in a case in which the muscle identifier satisfies a predetermined increase condition.

The muscle changing unit 334 performs change processing for decreasing a maximum power that is paired with a muscle identifier not determined by the muscle determining part 1321, in a case in which the muscle identifier satisfies a predetermined decrease condition. The muscle changing unit 334 may perform the same processing as the muscle changing unit 134.

The storage unit 31, the avatar storage unit 314, and the muscle storage unit 315 are preferably non-volatile recording media, but may alternately be realized by volatile recording media.

There is no limitation on the procedure in which information is stored in the storage unit 11 and the like. For example, information may be stored in the storage unit 31 and the like via a recording medium, information transmitted via a communication line or the like may be stored in the storage unit 31 and the like, or information input via an input device may be stored in the storage unit 11 and the like.

The processing unit 33, the movement determining unit 332, the moving unit 333, and the muscle changing unit 334 may be typically realized by processors, memories, or the like. Typically, the processing procedure of the processing unit 33 and the like is realized by software, and the software is stored in a recording medium such as a ROM. However, the processing procedure may be realized by hardware (dedicated circuits). The processors are, for example, CPUs, MPUs, GPUs, or the like, and there is no limitation on the type thereof.

Next, an operation example of the information processing apparatus 3 constituting the movement system B will be described. The operation example of the information processing apparatus 3 is the same as that described with reference to the flowchart in FIG. 2, except for the moving processing in step S206.

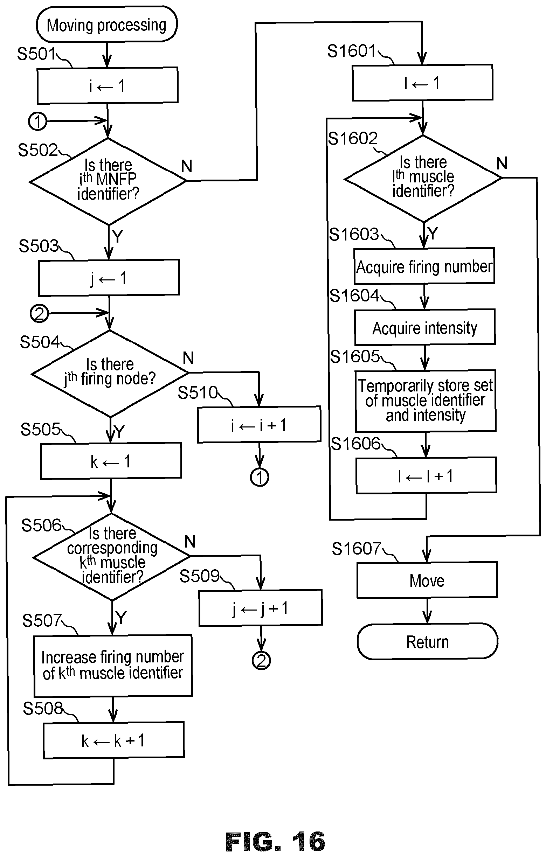

Hereinafter, an example of the moving processing that is performed by the information processing apparatus 3 will be described with reference to the flowchart in FIG. 16. In the flowchart in FIG. 16, a description of the same steps as in the flowchart in FIG. 5 has been omitted.

(Step S1601) The movement determining unit 132 substitutes 1 for a counter 1.

(Step S1602) The movement determining unit 132 determines whether or not there is an l^{th} muscle identifier whose corresponding firing number is one or more. If there is an l^{th} muscle identifier, the procedure advances to step S1603, or otherwise the procedure advances to step S1607.

(Step S1603) The movement determining unit 132 acquires a firing number corresponding to the l^{th} muscle identifier. If there is a maximum power corresponding to the l^{th} muscle identifier, the movement determining unit 132 acquires the firing number and the maximum power.

(Step S1604) The intensity acquiring part 1322 acquires an intensity using the firing number acquired in step S1603. The intensity acquiring part 1322 may acquire an intensity using the firing number and the maximum power.

(Step S1605) The movement determining unit 132 temporarily stores the l^{th} muscle identifier and the intensity that is acquired in step S1604 as a pair in an unshown buffer.

(Step S1606) The movement determining unit 132 increments the counter 1 by 1. The procedure returns to step S1602.

(Step S1607) The moving unit 133 contracts a muscle (in this case, typically a mesh) identified with each muscle identifier, by the amount corresponding to the intensity, using the one or more pairs of a muscle identifier and an intensity stored in the unshown buffer, thereby moving the movable object 4 (e.g., a face of an avatar). The procedure returns to the upper-level processing.

As described above, according to this embodiment, it is possible to appropriately simulate a movement of a face according to cognition of a living organism such as a person, the movement being a movement of a face according to accepted input information.

### Embodiment 3

This embodiment is different from the foregoing embodiments in the way in which a movable object is moved. In this embodiment, the movable object moves according to an acquired movement identifier.

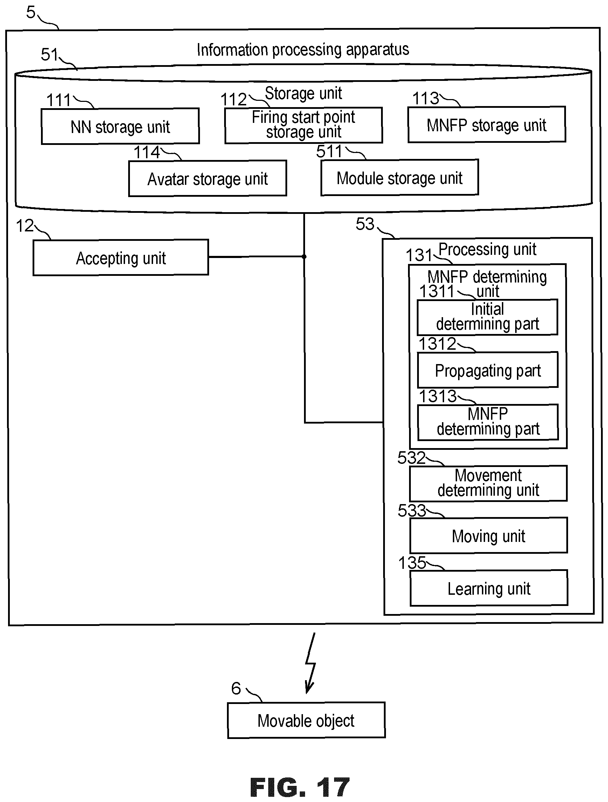

FIG. 17 is a block diagram of a movement system C in this embodiment. The movement system C includes an information processing apparatus 5 and a movable object 6. The information processing apparatus 5 may be configured to include the movable object 6.

The movable object 6 is an object that moves. The movable object 6 is, for example, an avatar or a robot, but the type thereof is not limited.

The information processing apparatus 5 includes a storage unit 51, an accepting unit 12, and a processing unit 53. The storage unit 51 includes an NN storage unit 111, a firing start point storage unit 112, an MNFP storage unit 113, an avatar storage unit 114, and a module storage unit 511. The processing unit 53 includes an MNFP determining unit 131, a movement determining unit 532, a moving unit 533, and a learning unit 135.

Various types of information are stored in the storage unit 51 constituting the information processing apparatus 5. The various types of information are, for example, a neural network (NN), firing start point information, an MNFP, avatar information, or a module.

One or two or more movement modules are stored in the module storage unit 511. Each movement module is a program for moving the movable object 6. The movement module is, for example, an execution module, a function, or a method, but the type thereof is not limited. The movement module is associated with the movement identifier. The movement identifier is information for identifying a movement. The movement identifier is, for example, a name of a movement module or an ID of a movement module.

The processing unit 53 performs various types of processing. The various types of processing are, for example, processing that is performed by the MNFP determining unit 131, the movement determining unit 532, the moving unit 533, and the learning unit 135.

The movement determining unit 532 sequentially acquires movement determination information respectively corresponding to the one or more MNFPs determined by the MNFP determining unit 131.

The movement determining unit 532 sequentially acquires movement identifiers respectively corresponding to the one or more MNFPs determined by the MNFP determining unit 131. The movement identifiers are associated with the MNFPs in the MNFP storage unit 113.

The moving unit 533 moves the movable object 6 sequentially using the one or more pieces of movement determination information acquired by the movement determining unit 532.

The moving unit 533 sequentially executes movement modules associated with the movement identifiers, acquired by the movement determining unit 532, thereby moving the movable object 6.

The storage unit 51 and the module storage unit 511 are preferably non-volatile recording media, but may alternately be realized by volatile recording media.

There is no limitation on the procedure in which information is stored in the storage unit 51 and the like. For example, information may be stored in the storage unit 51 and the like via a recording medium, information transmitted via a communication line or the like may be stored in the storage unit 51 and the like, or information input via an input device may be stored in the storage unit 51 and the like.

The processing unit 53, the movement determining unit 532, and the moving unit 533 may be typically realized by processors, memories, or the like. Typically, the processing procedure of the processing unit 53 and the like is realized by software, and the software is stored in a recording medium such as a ROM. However, the processing procedure may be realized by hardware (dedicated circuits). The processors are, for example, CPUs, MPUs, GPUs, or the like, and there is no limitation on the type thereof.

Next, an operation example of the information processing apparatus 5 constituting the movement system C will be described. The operation example of the information processing apparatus 3 is the same as that described with reference to the flowchart in FIG. 2, except for the moving processing in step S206.

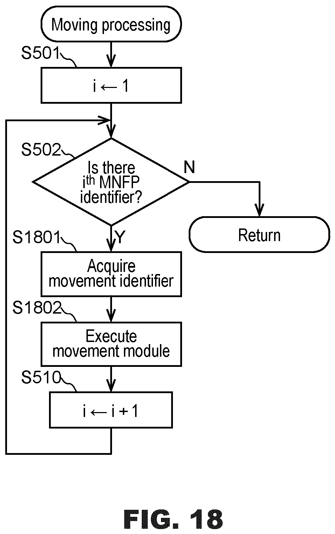

Hereinafter, an example of the moving processing that is performed by the information processing apparatus 3 will be described with reference to the flowchart in FIG. 18. In the flowchart in FIG. 18, a description of the same steps as in the flowchart in FIG. 5 has been omitted.

(Step S1801) The movement determining unit 532 acquires a movement identifier corresponding to the i^{th} MNFP from the MNFP storage unit 113.

(Step S1802) The moving unit 533 acquires a movement module identified with the movement identifier acquired in step S1801, from the module storage unit 511, and executes the movement module. The procedure advances to step S510.

As described above, according to this embodiment, it is possible to easily simulate a movement according to cognition of a living organism such as a person.

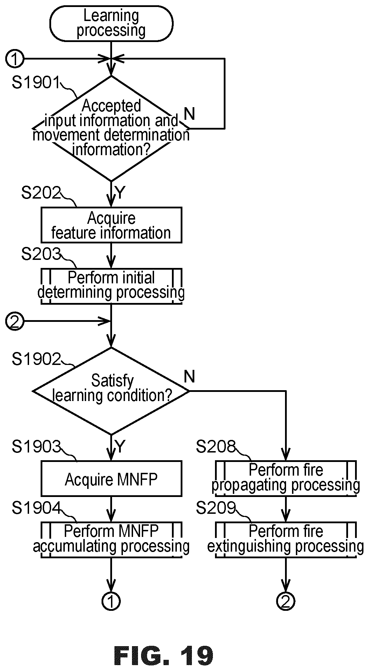

Hereinafter, an example of learning processing that is performed by the information processing apparatus 1 or the information processing apparatus 3 in the foregoing embodiments will be described with reference to the flowchart in FIG. 19. In the flowchart in FIG. 19, a description of the same steps as in the flowchart in FIG. 2 has been omitted. The learning processing is processing for learning an MNFP.

(Step S1901) The learning unit 135 determines whether or not it has accepted input information and movement determination information that are for use in learning. If it has accepted such information, the procedure advances to step S1902, or otherwise the procedure returns to step S1901. The movement determination information in this case is, for example, movement muscle information.

(Step S1902) The learning unit 135 determines whether or not a learning condition is satisfied. If a learning condition is satisfied, the procedure advances to step S1903, or otherwise the procedure advances to step S208.

The learning condition is a condition for accumulating an MNFP in the MNFP storage unit 113. The learning condition is, for example, a condition regarding the number of points in time or a condition regarding the firing information. The condition regarding the number of points in time is a condition regarding the number of points in time in the firing information accumulated in the firing information storage unit 117, and is, for example, that the number of points in time is greater than or equal to a threshold value. The condition regarding the firing information is a condition regarding the content of the firing information, and is, for example, that the number of firing nodes is greater than or equal to a threshold value.

(Step S1903) The learning unit 135 acquires an MNFP stored in the firing information storage unit 117 at the current point in time. The MNFP in this case is information for specifying a set of firing node identifiers at each point in time from the first point in time to the current point in time, and is, for example, the above-described matrix. The matrix is a matrix of two axes consisting of a time axis and a node identifier.

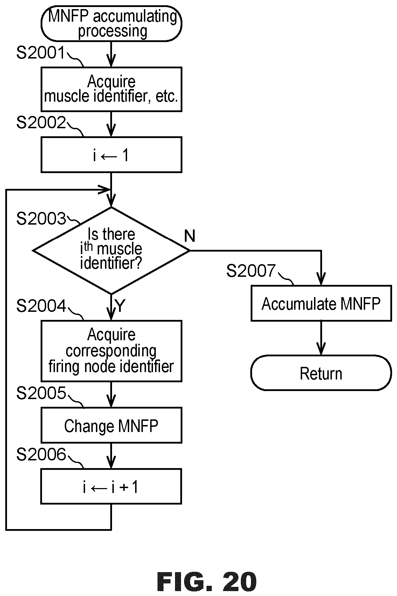

(Step S1904) The learning unit 135 performs the MNFP accumulating processing. An example of the MNFP accumulating processing will be described with reference to the flowchart in FIG. 20. The MNFP accumulating processing is processing for accumulating an MNFP in the MNFP storage unit 113.

In the flowchart in FIG. 19, the processing at the steps S203, S208, and S209 may be performed by the learning unit 135.

Next, an example of the MNFP accumulating processing in step S1904 will be described with reference to the flowchart in FIG. 20.

(Step S2001) The learning unit 135 acquires one or more muscle identifiers contained in the accepted movement determination information. The one or more muscle identifiers are identifiers of muscles that move in a case in which input information is accepted.

(Step S2002) The learning unit 135 substitutes 1 for a counter i.

(Step S2003) The learning unit 135 determines whether or not there is an i^{th} muscle identifier among the muscle identifiers acquired in step S2001. If there is an i^{th} muscle identifier, the procedure advances to step S2004, or otherwise the procedure advances to step S2007.

(Step S2004) The learning unit 135 refers to the muscle storage unit 315, and acquires one or more firing node identifiers corresponding to the i^{th} muscle identifier.

(Step S2005) The learning unit 135 sets the value of the nodes corresponding to the one or more firing node identifiers acquired in step S2004, the firing node identifiers being the node identifiers at the last point in time in the MNFP acquired in step S1903, to the value of a firing node (e.g., "1").

(Step S2006) The learning unit 135 increments the counter i by 1. The procedure returns to step S2003.

(Step S2007) The learning unit 135 accumulates the MNFP changed in step S2005, in the MNFP storage unit 113. The procedure returns to the upper-level processing.

Also, an example of the learning processing that is performed by the information processing apparatus 5 will be described. The learning processing in this case is different from the learning processing described with reference to FIG. 19, only in the MNFP accumulating processing.

The MNFP accumulating processing that is performed by the learning unit 135 of the information processing apparatus 5 is processing for accumulating the MNFP acquired in S1903 and the movement determination information accepted in S1901 in the MNFP storage unit 113 in association with each other. The movement determination information in this case is a movement identifier.

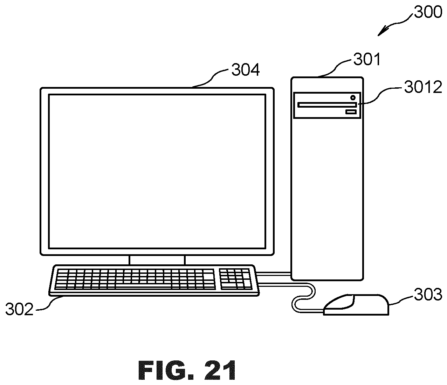

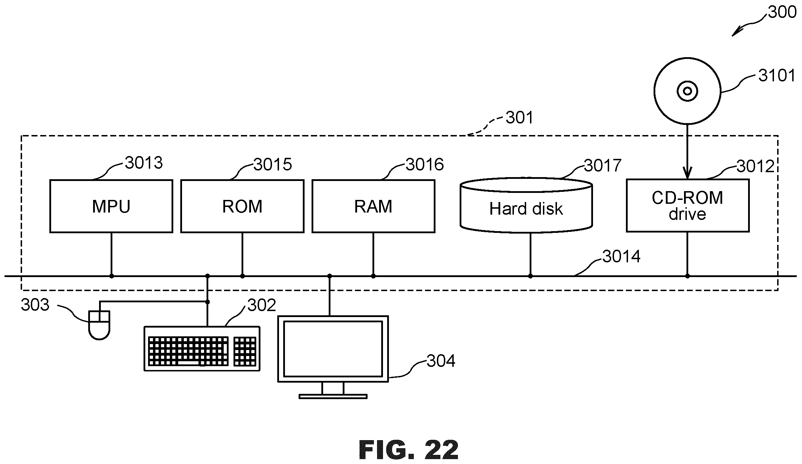

FIG. 21 shows the external appearance of a computer that executes the program described in this specification to realize the information processing apparatus 1 and the like in various embodiments described above. The foregoing embodiments may be realized using computer hardware and a computer program executed thereon. FIG. 21 is a schematic view of a computer system 300. FIG. 22 is a block diagram of the system 300.

In FIG. 21, the computer system 300 includes a computer 301 including a CD-ROM drive, a keyboard 302, a mouse 303, and a monitor 304.

In FIG. 22, the computer 301 includes, in addition to the CD-ROM drive 3012, an MPU 3013, a bus 3014 connected to the CD-ROM drive 3012 and the like, a ROM 3015 in which a program such as a boot up program is stored, a RAM 3016 that is connected to the MPU 3013 and is a memory in which a command of an application program is temporarily stored and a temporary storage area is provided, and a hard disk 3017 in which an application program, a system program, and data are stored. Although not shown, the computer 301 may further include a network card that provides connection to a LAN.

The program for causing the computer system 300 to execute the functions of the information processing apparatus 1 and the like in the foregoing embodiments may be stored in a CD-ROM 3101 that is inserted into the CD-ROM drive 3012, and be transmitted to the hard disk 3017. Alternatively, the program may be transmitted via a network (not shown) to the computer 301 and stored in the hard disk 3017. At the time of execution, the program is loaded into the RAM 3016. The program may be loaded from the CD-ROM 3101. Alternatively, the program may be loaded directly from a network.

The program does not necessarily have to include, for example, an operating system (OS) or a third party program to cause the computer 301 to execute the functions of the information processing apparatus 1 and the like in the foregoing embodiments. The program may only include a command portion to call an appropriate function (module) in a controlled mode and obtain desired results. The manner in which the computer system 300 operates is well known, and thus a detailed description thereof has been omitted.

It should be noted that, in the program, in a step of transmitting information, a step of receiving information, or the like, processing that is performed only by hardware, for example, processing performed by a modem or an interface card in the transmitting step (processing that can be performed only by hardware) is not included.

Furthermore, the computer that executes the program may be constituted by a single computer, or constituted by multiple computers.

That is to say, centralized processing may be performed, or distributed processing may be performed.

In the foregoing embodiments, each process may be realized as centralized processing using a single apparatus, or may be realized as distributed processing using multiple apparatuses.

The present invention is not limited to the embodiments set forth herein. Various modifications are possible within the scope of the present invention.

### Industrial Applicability

As described above, the information processing apparatus 1 according to the present invention has the effect of making it possible to appropriately simulate a movement according to cognition of a living organism such as a person, thus rendering this apparatus useful as a simulation apparatus and the like.

### List of Reference Numerals

- 1, 3, 5: Information processing apparatus
- 2, 4, 6: Movable object
- 11, 31, 51: Storage unit
- 12: Accepting unit
- 13, 33, 53: Processing unit
- 111: NN storage unit
- 112: Firing start point storage unit
- 113: MNFP storage unit
- 114, 314: Avatar storage unit
- 115, 315: Muscle storage unit
- 116: Joint storage unit
- 117: Firing information storage unit
- 121: Input accepting unit
- 131: MNFP determining unit
- 132, 332, 532: Movement determining unit
- 133, 333, 533: Moving unit
- 134, 334: Muscle changing unit
- 135: Learning unit
- 511: Module storage unit
- 1311: Initial determining part
- 1312: Propagating part
- 1313: MNFP determining part
- 1321: Muscle determining part
- 1322: Intensity acquiring part
- 1323: Angle acquiring part

## Claims

1. An information processing apparatus comprising:
a neural network (NN) storage unit in which a neural network having two or more nodes each identified with a node identifier is stored;
a motor neuron firing pattern (MNFP) storage unit in which one or two or more MNFPs, each of which is information for specifying one or more firing nodes at each of two or more points in time, are stored in association with movement determination information for determining a movement of a movable object;
an input accepting unit that accepts input information;
an MNFP determining unit that applies the input information to the neural network, thereby acquiring, in a time series, one or more firing node identifiers of the two or more nodes included in the neural network, and sequentially determines one or more MNFPs corresponding to the one or more time-series firing node identifiers, out of the one or more MNFPs in the MNFP storage unit;
a movement determining unit that sequentially acquires movement determination information respectively corresponding to the one or more MNFPs determined by the MNFP determining unit; and
a moving unit that moves the movable object sequentially using the one or more pieces of movement determination information acquired by the movement determining unit.

2. The information processing apparatus according to claim 1, further comprising:
a muscle storage unit in which two or more pieces of muscle information are stored, each of which is information on a muscle that moves in a case in which the one or more nodes fire, is information associated with one or more firing node identifiers, and is information indicating a muscle identifier and a maximum power,
wherein the movement determining unit includes:
a muscle determining part that sequentially determines one or more pieces of muscle information associated with each of one or more firing node identifiers specified with the one or more MNFPs determined by the MNFP determining unit; and
an intensity acquiring part that acquires, for each of the one or more pieces of muscle information determined by the muscle determining part, a firing number, which is the number of firing node identifiers associated with the muscle information, and sequentially acquires intensities of movements of the muscles specified with the muscle information, using the firing number and the maximum power that is indicated by the muscle information, and
the moving unit sequentially moves the movable object based on one or more pieces of movement muscle information, each of which is a pair of a muscle identifier contained in each of the one or more pieces of muscle information determined by the muscle determining part and the intensity acquired by the intensity acquiring part.

3. The information processing apparatus according to claim 1, further comprising:
a joint storage unit in which one or more pieces of joint information each having a joint identifier are stored in association with two or more muscle identifiers,
wherein the movement determining unit further includes:
an angle acquiring part that refers to the joint storage unit, and sequentially acquires angles of joints respectively identified with one or more joint identifiers associated with muscle identifiers contained in the one or more pieces of muscle information determined by the muscle determining part, using the one or more pieces of movement muscle information, and
the moving unit outputs the angles of the respective one or more joints to the movable object, thereby moving the movable object.

4. The information processing apparatus according to claim 3,
wherein the movable object is an avatar,
the joint information is information on a joint of the avatar, and indicates a joint position for specifying a position of a joint included in the avatar,
the information processing apparatus further comprises an avatar storage unit in which avatar information for outputting the avatar is stored,
the moving unit configures an avatar whose joints respectively specified with the joint positions of the one or more joints have been bent according to the angles corresponding to the joints, using the avatar information, and outputs the avatar.

5. The information processing apparatus according to claim 1,
wherein the movable object is a face of an avatar,
the information processing apparatus further comprises a muscle storage unit in which two or more pieces of muscle information are stored, each of which is information associated with node identifiers of one or more nodes, is information on a mesh that moves in a case in which the one or more nodes fire, and has a muscle identifier for identifying a mesh of the face of the avatar;
the movement determining unit includes:
a muscle determining part that sequentially determines one or more pieces of muscle information associated with each of one or more firing node identifiers specified with the one or more MNFPs determined by the MNFP determining unit, and
the moving unit sequentially stretches or contracts meshes identified with muscle identifiers contained in the muscle information determined by the muscle determining part.

6. The information processing apparatus according to claim 5,
wherein the movement determining unit includes:
a muscle determining part that sequentially determines one or more pieces of muscle information associated with each of one or more firing node identifiers specified with the one or more MNFPs determined by the MNFP determining unit; and
an intensity acquiring part that acquires, for each of the one or more pieces of muscle information determined by the muscle determining part, a firing number, which is the number of firing node identifiers associated with the muscle information, and sequentially acquires intensities of movements of the muscles specified with the muscle information, using the firing number, and
the moving unit sequentially moves the movable object based on one or more pieces of movement muscle information, each of which is a pair of a muscle identifier contained in each of the one or more pieces of muscle information determined by the muscle determining part and the intensity acquired by the intensity acquiring part.

7. The information processing apparatus according to claim 1,
wherein the movement determination information is a movement identifier for identifying a movement,
the information processing apparatus further comprises a module storage unit in which a movement module for moving the movable object is stored in association with the movement identifier,
the movement determining unit acquires a movement identifier corresponding to the MNFP determined by the MNFP determining unit, and
the moving unit executes the movement module associated with the movement identifier acquired by the movement determining unit, thereby moving the movable object.

8. The information processing apparatus according to any one of claims 2 to 4, further comprising:
a muscle changing unit that performs change processing for increasing a maximum power that is paired with a muscle identifier determined by the muscle determining part, in a case in which the muscle identifier satisfies a predetermined increase condition.

9. The information processing apparatus according to any one of claims 2 to 4, further comprising:
a muscle changing unit that performs change processing for decreasing a maximum power that is paired with a muscle identifier not determined by the muscle determining part, in a case in which the muscle identifier satisfies a predetermined decrease condition.

10. The information processing apparatus according to any one of claims 1 to 9, further comprising:
a learning unit that performs learning processing for acquiring an MNFP in a case in which the input accepting unit accepts input information, accepts movement determination information, and accumulates the MNFP in the MNFP storage unit in association with the movement determination information.

11. The information processing apparatus according to any one of claims 1 to 9,
wherein each of one or more nodes among the two or more nodes included in the neural network is associated with a firing condition, and is associated with one or more connected node identifiers for identifying another node to which firing is to be propagated, and
the MNFP determining unit includes:
an initial determining part that acquires one or more pieces of feature information from the input information accepted by the input accepting unit, determines a firing condition that matches the one or more pieces of feature information, and acquires one or more firing node identifiers corresponding to the firing condition;
a propagating part that acquires one or more connected node identifiers corresponding to each of the one or more firing node identifiers acquired by the initial determining part, and then sequentially acquires one or more connected node identifiers corresponding to each of the one or more connected node identifiers; and
an MNFP determining part that acquires, in a time series, firing information having one or more firing node identifiers among the one or more firing node identifiers and the one or more connected node identifiers acquired by the initial determining part and the propagating part, and sequentially determines one or more MNFPs corresponding to the time-series firing information out of the one or more MNFPs in the MNFP storage unit.

12. The information processing apparatus according to any one of claims 1 to 11, wherein the number of points in time is different between at least two MNFPs among the two or more MNFPs.

13. An information processing method realized using: a neural network (NN) storage unit in which a neural network having two or more nodes each identified with a node identifier is stored; a motor neuron firing pattern (MNFP) storage unit in which one or more pieces of control information are stored, each of which is information containing one or two or more MNFPs for specifying one or more firing nodes at each of two or more points in time, and is information corresponding to movement determination information for determining a movement of a movable object; an input accepting unit; an MNFP determining unit; a movement determining unit; and a moving unit, comprising:
an input accepting step of the input accepting unit accepting input information;
an MNFP determining step of the MNFP determining unit applying the input information to the neural network, thereby acquiring, in a time series, one or more firing node identifiers of the two or more nodes included in the neural network, and sequentially determining one or more MNFPs corresponding to the one or more time-series firing node identifiers, out of the one or more MNFPs in the MNFP storage unit;
a movement determining step of the movement determining unit sequentially acquiring movement determination information respectively corresponding to the one or more MNFPs determined in the MNFP determining step; and
a moving step of the moving unit moving the movable object sequentially using the one or more pieces of movement determination information acquired in the movement determining step.

14. A program for causing a computer capable of accessing: a neural network (NN) storage unit in which a neural network having two or more nodes each identified with a node identifier is stored; and a motor neuron firing pattern (MNFP) storage unit in which one or more pieces of control information are stored, each of which is information containing one or two or more MNFPs for specifying one or more firing nodes at each of two or more points in time, and is information corresponding to movement determination information for determining a movement of a movable object, to function as:
an input accepting unit that accepts input information;
an MNFP determining unit that applies the input information to the neural network, thereby acquiring, in a time series, one or more firing node identifiers of the two or more nodes included in the neural network, and sequentially determines one or more MNFPs corresponding to the one or more time-series firing node identifiers, out of the one or more MNFPs in the MNFP storage unit;
a movement determining unit that sequentially acquires movement determination information respectively corresponding to the one or more MNFPs determined by the MNFP determining unit; and
a moving unit that moves the movable object sequentially using the one or more pieces of movement determination information acquired by the movement determining unit.
